(19) Europäisches Patentamt
European Patent Office
Office européen des brevets

(11) EP 4 474 162 A1

(12) **EUROPEAN PATENT APPLICATION**
published in accordance with Art. 153(4) EPC

(43) Date of publication:
**11.12.2024 Bulletin 2024/50**

(21) Application number: **23747181.8**

(22) Date of filing: **31.01.2023**

(51) International Patent Classification (IPC):
***B41N 1/14*** (2006.01) ***B41C 1/10*** (2006.01)
***B41M 1/06*** (2006.01) ***G03F 7/00*** (2006.01)
***G03F 7/004*** (2006.01) ***G03F 7/028*** (2006.01)
***G03F 7/029*** (2006.01) ***G03F 7/11*** (2006.01)

(52) Cooperative Patent Classification (CPC):
**B41C 1/10; B41M 1/06; B41N 1/14; G03F 7/00; G03F 7/004; G03F 7/028; G03F 7/029; G03F 7/11**

(86) International application number:
**PCT/JP2023/003123**

(87) International publication number:
**WO 2023/145971 (03.08.2023 Gazette 2023/31)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **31.01.2022 JP 2022013338**

(71) Applicant: **FUJIFILM Corporation**
**Tokyo 106-8620 (JP)**

(72) Inventor: **NAMBA, Yusuke**
**Haibara-gun, Shizuoka 421-0396 (JP)**

(74) Representative: **HGF**
**HGF Limited**
**1 City Walk**
**Leeds LS11 9DX (GB)**

# (54) ON-PRESS-DEVELOPING PLANOGRAPHIC PRINTING PLATE ORIGINAL PLATE, METHOD FOR PRODUCING PLANOGRAPHIC PRINTING PLATE, AND PLANOGRAPHIC PRINTING METHOD

(57) An on-press development type lithographic printing plate precursor including a support and an image-recording layer on the support, in which the image-recording layer contains a polymerization initiator, an infrared absorber, a color forming substance precursor, and an auxiliary capable of donating an electron to the infrared absorber, and a polymer having an ethylenically unsaturated group and a water-soluble monofunctional monomer are present on a surface of the support on an image-recording layer side, a layer in contact with the support on the image-recording layer side contains the polymer having an ethylenically unsaturated group and the water-soluble monofunctional monomer, or a layer in contact with the support on the image-recording layer side, other than the image-recording layer, contains the polymer having an ethylenically unsaturated group and the image-recording layer contains the water-soluble monofunctional monomer, and a method of preparing a lithographic printing plate and a lithographic printing method using the on-press development type lithographic printing plate precursor.

EP 4 474 162 A1

## Description

## BACKGROUND OF THE INVENTION

1. Field of the Invention

The present disclosure relates to an on-press development type lithographic printing plate precursor, a method of preparing a lithographic printing plate, and a lithographic printing method.

2. Description of the Related Art

In general, a lithographic printing plate is composed of lipophilic image areas that receive ink during a printing process and hydrophilic non-image areas that receive a dampening water. Lithographic printing is a printing method that utilizes the property that water and oil-based ink repel each other to cause differences in ink attachment behavior on a surface of the lithographic printing plate by using lipophilic image areas on the lithographic printing plate as an ink-receiving area and using hydrophilic non-image areas on the lithographic printing plate as dampening water-receiving areas (non-ink-receiving areas), thereby depositing the ink only to the image areas, and then transferring the ink to a printing material, such as paper.

In the related art, in order to prepare this lithographic printing plate, a lithographic printing plate precursor (PS plate) has been widely used which is obtained by providing a lipophilic photosensitive resin layer (image-recording layer) on a hydrophilic support. Usually, a lithographic printing plate is obtained by a plate making method of exposing a lithographic printing plate precursor through an original picture such as a lith film, then keeping a portion of an image-recording layer that will be an image area while removing other unnecessary portions of the image-recording layer by dissolving such portions in an alkaline developer or an organic solvent, and forming a non-image area by exposing a surface of the hydrophilic support.

In response to the intensifying interest in the global environment, an environmental issue of waste liquid generated by wet treatments such as a development treatment has gathered more attention.

Regarding the environmental issue described above, an attempt is made to simplify development or plate making or to remove treatments. As one of simple preparation methods, a method called "on-press development" is being carried out. That is, the on-press development is a method of exposing a lithographic printing plate precursor, then immediately mounting the precursor on a printer without performing development of the related art, and removing an unnecessary portion of the image-recording layer at an initial stage of the ordinary printing step.

In the present disclosure, a lithographic printing plate precursor that can be used for such on-press development is called "on-press development type lithographic printing plate precursor".

Examples of the lithographic printing plate precursors in the related art include those described in JP2002-287334A.

JP2002-287334A describes a lithographic printing plate precursor including, on a support, a photosensitive layer that contains (A) an infrared absorber, (B) a radical polymerization initiator, and (C) a radically polymerizable compound, and is water-soluble or water-dispersible, in which the lithographic printing plate precursor is capable of being recorded by irradiation with infrared ray.

## SUMMARY OF THE INVENTION

An object of an embodiment of the present disclosure is to provide an on-press development type lithographic printing plate precursor excellent in printing durability, visibility, and temporal on-press developability.

An object of another embodiment of the present disclosure is to provide a method of preparing a lithographic printing plate and a lithographic printing method in which the on-press development type lithographic printing plate precursor is used.

Means for solving the above issues include the following aspects.

<1> An on-press development type lithographic printing plate precursor comprising a support and an image-recording layer on the support, in which the image-recording layer contains a polymerization initiator, an infrared absorber, a color forming substance precursor, and an auxiliary capable of donating an electron to the infrared absorber, and a polymer having an ethylenically unsaturated group and a water-soluble monofunctional monomer are present on a surface of the support on an image-recording layer side, a layer in contact with the support on the image-recording layer side contains the polymer having an ethylenically unsaturated group and the water-soluble monofunctional monomer, or a layer in contact with the support on the image-recording layer side, other than the image-recording layer, contains the polymer having an ethylenically unsaturated group and the image-recording layer contains the

water-soluble monofunctional monomer.

<2> The on-press development type lithographic printing plate precursor according to <1>, in which the polymer having an ethylenically unsaturated group has a polyalkylene oxide chain.

<3> The on-press development type lithographic printing plate precursor according to <2>, in which the polymer having an ethylenically unsaturated group is a polymer having a constitutional unit having the polyalkylene oxide chain and a constitutional unit having the ethylenically unsaturated group.

<4> The on-press development type lithographic printing plate precursor according to any one of <1> to <3>, in which a content of the polymer having an ethylenically unsaturated group per unit area of the on-press development type lithographic printing plate precursor is 1 $mg/m^2$ to 30 $mg/m^2$.

<5> The on-press development type lithographic printing plate precursor according to any one of <1> to <4>, in which a ratio $M^B/M^A$ of a content $M^B$ of the water-soluble monofunctional monomer to a content $M^A$ of the polymer having an ethylenically unsaturated group per unit area of the on-press development type lithographic printing plate precursor is 0.8 to 10.

<6> The on-press development type lithographic printing plate precursor according to any one of <1> to <5>, in which the water-soluble monofunctional monomer has a support absorptive group.

<7> The on-press development type lithographic printing plate precursor according to <6>, in which the support absorptive group contained in the water-soluble monofunctional monomer is at least one group selected from the group consisting of a phenolic hydroxy group, a carboxy group, $-PO_3H_2$, $-OPO_3H_2$, $-CONHSO_2-$, $-SO_2NHSO_2-$, and $-COCH_2COCH_3$.

<8> The on-press development type lithographic printing plate precursor according to any one of <1> to <7>, in which the polymer having an ethylenically unsaturated group and the water-soluble monofunctional monomer are present on the surface of the support on the image-recording layer side.

<9> The on-press development type lithographic printing plate precursor according to any one of <1> to <8>, in which the polymer having an ethylenically unsaturated group and the water-soluble monofunctional monomer are absorbed on the surface of the support on the image-recording layer side.

<10> The on-press development type lithographic printing plate precursor according to any one of <1> to <9>, further comprising an undercoat layer between the support and the image-recording layer, in which the undercoat layer contains the polymer having an ethylenically unsaturated group and the water-soluble monofunctional monomer.

<11> The on-press development type lithographic printing plate precursor according to any one of <1> to <10>, in which the polymerization initiator is an onium compound.

<12> The on-press development type lithographic printing plate precursor according to any one of <1> to <11>, in which the auxiliary capable of donating an electron to the infrared absorber is a borate compound.

<13> The on-press development type lithographic printing plate precursor according to any one of <1> to <12>, in which a molar absorption coefficient $\varepsilon$ of a color forming substance generated from the color forming substance precursor is 35,000 or more, a ring-opening ratio of the color forming substance precursor, which is obtained by the following expression, is 40 mol% to 99 mol%, and a maximum absorption wavelength of the color forming substance generated from the color forming substance precursor, in a wavelength range of 380 nm to 750 nm, is 500 nm to 650 nm.

Ring-opening ratio = molar absorption coefficient of the color forming substance obtained in case of adding 1 molar equivalent of acid to the color forming substance precursor/molar absorption coefficient $\varepsilon$ of the color forming substance generated from the color forming substance precursor $\times$ 100

<14> A method of preparing a lithographic printing plate, comprising a step of exposing the on-press development type lithographic printing plate precursor according to any one of <1> to <13> in a shape of an image, and a step of supplying at least one selected from the group consisting of a printing ink and dampening water on a printer to remove an image-recording layer in a non-image area.

<15> A lithographic printing method comprising a step of exposing the on-press development type lithographic printing plate precursor according to any one of <1> to <13> in a shape of an image, a step of supplying at least one selected from the group consisting of a printing ink and dampening water on a printer to remove an image-recording layer in a non-image area and to prepare a lithographic printing plate, and a step of performing printing using the obtained lithographic printing plate.

According to an embodiment of the present disclosure, it is possible to provide an on-press development type lithographic printing plate precursor excellent in printing durability, visibility, and temporal on-press developability.

According to another embodiment of the present disclosure, it is possible to provide a method of preparing a lithographic printing plate and a lithographic printing method in which the on-press development type lithographic printing plate precursor is used.

## BRIEF DESCRIPTION OF THE DRAWINGS

Fig. 1 is a schematic cross-sectional view of an embodiment of an aluminum support suitably used in the present disclosure.
Fig. 2 is a schematic cross-sectional view of an embodiment of an aluminum support having an anodic oxide film.
Fig. 3 is a graph showing an example of an alternating waveform current waveform diagram used for an electrochemical roughening treatment in a manufacturing method of an aluminum support having an anodic oxide film.
Fig. 4 is a lateral view showing an example of a radial cell in an electrochemical roughening treatment using alternating current in a manufacturing method of an aluminum support having an anodic oxide film.

## DESCRIPTION OF THE PREFERRED EMBODIMENTS

Hereinafter, the contents of the present disclosure will be described in detail. The description of configuration requirements below is made based on representative embodiments of the present disclosure in some cases, but the present disclosure is not limited to such embodiments.

In the present specification, a numerical range expressed using "to" includes numerical values listed before and after "to" as the lower limit value and the upper limit value.

In addition, in the present specification, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).

In the present specification, "(meth)acryl" is a term used to explain a concept including both the acryl and methacryl, and "(meth)acryloyl" is a term used to explain a concept including both the acryloyl and methacryloyl.

In addition, the term "step" in the present specification means not only an independent step but also a step that cannot be clearly differentiated from other steps as long as the intended goal of the step is achieved. In the present disclosure, "% by mass" has the same definition as "% by weight", and "part by mass" has the same definition as "part by weight".

In the present disclosure, unless otherwise specified, as each component contained in a composition or each constitutional unit contained in a polymer, one component or one constitutional unit may be used alone, or two or more components or two or more constitutional units may be used in combination.

Furthermore, in the present disclosure, in a case where there is a plurality of substances corresponding to each component in a composition, or in a case where there is a plurality of constitutional units corresponding to each constitutional unit in a polymer, unless otherwise specified, the amount of each component in the composition or the amount of each constitutional unit in the polymer means the total amount of the plurality of corresponding substances present in the composition or the total amount of the plurality of corresponding constitutional units present in the polymer.

Furthermore, in the present disclosure, a combination of two or more preferred aspects is a more preferred aspect.

In addition, in the present disclosure, unless otherwise specified, each of the weight-average molecular weight (Mw) and number-average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

In the present disclosure, the term "lithographic printing plate precursor" refers not only to a lithographic printing plate precursor but also to a key plate precursor. In addition, the term "lithographic printing plate" refers not only to a lithographic printing plate prepared by performing operations such as exposure and development as necessary on a lithographic printing plate precursor but also to a key plate. The key plate precursor is not necessarily subjected to the operations such as exposure and development. The key plate refers to a lithographic printing plate precursor to be mounted on a plate cylinder that is not used, in a case where monochromatic or dichromatic printing is carried out on a part of paper during, for example, color newspaper printing.

In the present disclosure, "excellent in printing durability" means the large number of sheets can be printed using the lithographic printing plate.

Hereinafter, the present disclosure will be described in detail.

(On-press development type lithographic printing plate precursor)

The on-press development type lithographic printing plate precursor according to the present disclosure includes

a support and an image-recording layer on the support, in which the image-recording layer contains a polymerization initiator, an infrared absorber, a color forming substance precursor, and an auxiliary capable of donating an electron to the infrared absorber, and a polymer having an ethylenically unsaturated group and a water-soluble monofunctional monomer are present on a surface of the support on an image-recording layer side, a layer in contact with the support on the image-recording layer side contains the polymer having an ethylenically unsaturated group and the water-soluble monofunctional monomer, or a layer in contact with the support on the image-recording layer side, other than the image-recording layer, contains the polymer having an ethylenically unsaturated group and the image-recording layer contains the water-soluble monofunctional monomer.

There is a problem that in the on-press development type lithographic printing plate precursor in the related art, during the passage of time, polymerization initiation species are generated by decomposition of the polymerization initiator, and dark polymerization of a polymer having an ethylenically unsaturated group, particularly a polymer having an ethylenically unsaturated group present in the vicinity of a support, proceeds, which causes to deteriorate on-press developability. In addition, in order to prevent the dark polymerization, it is effective to add a polymerization inhibitor to the image-recording layer, but in this case, there is a problem that the printing durability is deteriorated as a disadvantage.

In the on-press development type lithographic printing plate precursor according to the present disclosure, a polymer having an ethylenically unsaturated group and a water-soluble monofunctional monomer are present on a surface of the support on an image-recording layer side, a layer in contact with the support on the image-recording layer side contains the polymer having an ethylenically unsaturated group and the water-soluble monofunctional monomer, or a layer in contact with the support on the image-recording layer side other than the image-recording layer contains the polymer having an ethylenically unsaturated group and the image-recording layer contains the water-soluble monofunctional monomer. Therefore, since polymerization initiation species generated is captured to suppress that the polymer having an ethylenically unsaturated group is subjected to dark polymerization to form a crosslinked resin, in which developability, particularly on-press developability is deteriorated, and a polymerized substance of the water-soluble monofunctional monomer subjected to dark polymerization has high polarity and a three-dimensional network cannot be formed by dark polymerization, on-press developability is not deteriorated, and the influence on the color forming substance generated from the color forming substance precursor is small. Then, the on-press development type lithographic printing plate precursor in which deterioration of printing durability is suppressed, and visibility and on-press developability over time (also referred to as "temporal on-press developability") are excellent.

Hereinafter, each of the configuration requirements in the lithographic printing plate precursor according to the present disclosure will be specifically described.

In the on-press development type lithographic printing plate precursor according to the present disclosure, a polymer having an ethylenically unsaturated group and a water-soluble monofunctional monomer are present on a surface of the support on an image-recording layer side, a layer in contact with the support on the image-recording layer side contains the polymer having an ethylenically unsaturated group and the water-soluble monofunctional monomer, or a layer in contact with the support on the image-recording layer side, other than the image-recording layer, contains the polymer having an ethylenically unsaturated group and the image-recording layer contains the water-soluble monofunctional monomer.

In addition, in the on-press development type lithographic printing plate precursor according to the present disclosure, a polymer having an ethylenically unsaturated group and a water-soluble monofunctional monomer may be present on a surface of the support on the image-recording layer side, and a layer in contact with the support on the image-recording layer side may contain a polymer having an ethylenically unsaturated group and, as necessary, a water-soluble monofunctional monomer.

In the on-press development type lithographic printing plate precursor according to the present disclosure, as an aspect in which the polymer having an ethylenically unsaturated group and the water-soluble monofunctional monomer are present on the surface of the support on the image-recording layer side, an aspect in which the polymer having an ethylenically unsaturated group and the water-soluble monofunctional monomer are absorbed on the surface of the support on the image-recording layer side is preferable.

Examples of a case of an aspect in which the polymer having an ethylenically unsaturated group and the water-soluble monofunctional monomer are absorbed on the surface of the support on the image-recording layer side include a case where the polymer having an ethylenically unsaturated group and the water-soluble monofunctional monomer are used as a surface treatment agent of the support, a case where an undercoat layer containing the polymer having an ethylenically unsaturated group and the water-soluble monofunctional monomer is thinly formed, and a case where an undercoat layer containing the polymer having an ethylenically unsaturated group and the water-soluble monofunctional monomer is mixed with the image-recording layer at the time of the production of the lithographic printing plate precursor.

Examples of a method for confirming the aspect in which the polymer having an ethylenically unsaturated group and the water-soluble monofunctional monomer are absorbed on the surface of the support on the image-recording layer side include a method of removing a layer on the support such as the image forming layer with an organic solvent, sufficiently washing the support with pure water, and then detecting the absorbate on the surface of the support by element

analysis using fluorescent X-rays.

In addition, in the on-press development type lithographic printing plate precursor according to the present disclosure, as an aspect in which the layer in contact with the support on the image-recording layer side contains a polymer having an ethylenically unsaturated group and a water-soluble monofunctional monomer, an aspect in which the on-press development type lithographic printing plate precursor has an undercoat layer between the support and the image-recording layer, and the undercoat layer contains the polymer having an ethylenically unsaturated group and the water-soluble monofunctional monomer is preferable.

Furthermore, in the on-press development type lithographic printing plate precursor according to the present disclosure, as an aspect in which a layer in contact with the support on the image-recording layer side, other than the image-recording layer, contains the polymer having an ethylenically unsaturated group and the image-recording layer contains the water-soluble monofunctional monomer, an aspect in which the on-press development type lithographic printing plate precursor has an undercoat layer between the support and the image-recording layer, the undercoat layer contains a polymer having an ethylenically unsaturated group, and the image-recording layer contains a water-soluble monofunctional monomer is preferable.

In the present disclosure, "water-soluble" means that the solubility in 100 g of water having a liquid temperature of 22°C and a pH of 7.0 is 0.1 g or more.

<Water-soluble monofunctional monomer>

The water-soluble monofunctional monomer in the present disclosure is a monomer having only one ethylenically unsaturated group, and from the viewpoints of printing durability and on-press developability over time, preferably has a support absorptive group.

From the viewpoints of reactivity, printing durability, and on-press developability over time, the water-soluble monofunctional monomer preferably has a (meth)acryl group and more preferably has a (meth)acryloxy group as the ethylenically unsaturated group.

Examples of the support absorptive group include an onium salt group, a phosphate ester group, a phosphonate group, a borate group, a β-diketone group, a carboxylic acid group, a carboester group, a hydroxy group, a carbamoyl group, and the like.

From the viewpoints of printing durability and on-press developability over time, the support absorptive group is preferably an acid group or a cationic group, and more preferably an acid group.

The acid group preferably has an acid dissociation constant (pKa) of 7 or less. From the viewpoints of printing durability and on-press developability over time, the acid group is preferably at least one group selected from the group consisting of a phenolic hydroxyl group, a carboxy group, $-PO_3H_2$, $-OPO_3H_2$, $-CONHSO_2-$, $-SO_2NHSO_2-$, and $-COCH_2COCH_3-$, more preferably $-OPO_3H_2$ or $-PO_3H_2$, and particularly preferably $-OPO_3H_2$. In addition, these acid groups may be a metal salt.

The cationic group is preferably an onium group. Examples of the onium group include an ammonium group, a phosphonium group, an arsonium group, a stibonium group, an oxonium group, a sulfonium group, a selenonium group, a stannonium group, an iodonium group, and the like. Among these, an ammonium group, a phosphonium group, or a sulfonium group is preferable, an ammonium group or a phosphonium group is more preferable, and an ammonium group is particularly preferable.

The water-soluble monofunctional monomer is preferably a compound represented by Formula (I) or Formula (II), and more preferably a compound represented by Formula (I).

(I)

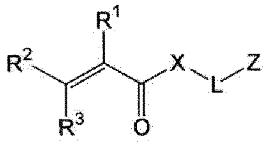

(II)

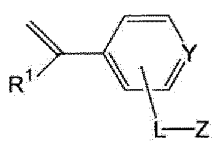

In Formula (I), $R^1$, $R^2$, and $R^3$ each independently represent a hydrogen atom, a halogen atom, or an alkyl group having 1 to 6 carbon atoms (also referred to as the "carbon number"). $R^1$, $R^2$, and $R^3$ are each independently preferably a hydrogen atom or an alkyl group having 1 to 6 carbon atoms, and more preferably a hydrogen atom or a methyl group. In addition, it is particularly preferable that $R^2$ and $R^3$ are a hydrogen atom.

In Formula (I), X represents an oxygen atom (-O-) or imino (-NH-), and is preferably an oxygen atom.

In Formula (I), L represents a divalent linking group, and is preferably a divalent aliphatic group (for example, an alkylene group, a substituted alkylene group, an alkenylene group, a substituted alkenylene group, an alkynylene group, or a substituted alkynylene group), a divalent aromatic group (for example, an arylene group or a substituted arylene group),

or a divalent heterocyclic group, or a combination of these with an oxygen atom (-O-), a sulfur atom (-S-), an imino (-NH-), a substituted imino (-NR-, R represents an aliphatic group, an aromatic group, or a heterocyclic group), or a carbonyl (-CO-).

The aliphatic group may have a cyclic structure or a branched structure. The carbon number of the aliphatic group is preferably 1 to 20, more preferably 1 to 15, and still more preferably 1 to 10. As the aliphatic group, a saturated aliphatic group is preferable than an unsaturated aliphatic group. The aliphatic group may have a substituent. Examples of the substituent include a halogen atom, a hydroxy group, an aromatic group, and a heterocyclic group.

The carbon number of the aromatic group is preferably 6 to 20, more preferably 6 to 15, and still more preferably 6 to 10. The aromatic group may have a substituent. Examples of the substituent include a halogen atom, a hydroxyl group, an aliphatic group, an aromatic group, and a heterocyclic group.

The heterocyclic group preferably contains a 5-membered ring or a 6-membered ring as a heterocyclic ring. The heterocyclic ring may be condensed with another heterocyclic ring, an aliphatic ring, or an aromatic ring. The heterocyclic group may have a substituent. Examples of the substituent include a halogen atom, a hydroxyl group, an oxo group (=O), a thioxo group (=S), an imino group (=NH), a substituted imino group (=N-R, R is an aliphatic group, an aromatic group, or a heterocyclic group), an aliphatic group, an aromatic group, and a heterocyclic group.

L is preferably a divalent linking group including a plurality of polyoxyalkylene structures. The polyoxyalkylene structure is more preferably a polyoxyethylene structure. In other words, it is preferable that L includes $-(OCH_2CH_2)_n-$ (n is an integer in a range of 2 or more).

In Formula (I), Z represents a support absorptive group.

In Formula (II), $R^1$, L, and Z each have the same meaning as $R^1$, L, and Z in Formula (I).

In addition, Y in Formula (II) represents a carbon atom or a nitrogen atom. In a case where Y is a nitrogen atom and L is bonded onto Y to form a quaternary pyridinium group, Z is not essential because the quaternary pyridinium group itself exhibits adsorptivity to the support.

An example of the monofunctional monomer having a preferable water solubility is shown below. Me represents a methyl group, and Et represents an ethyl group.

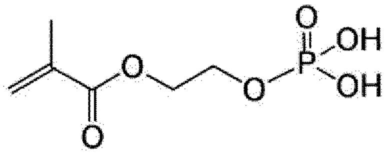

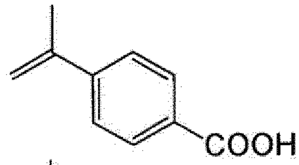

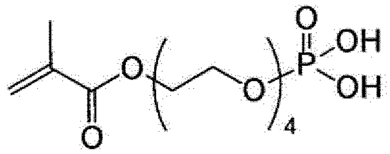

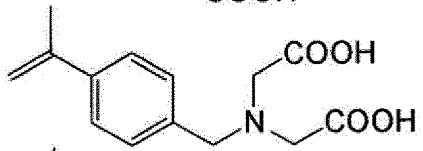

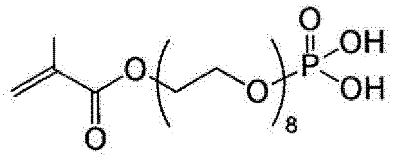

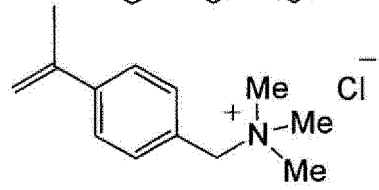

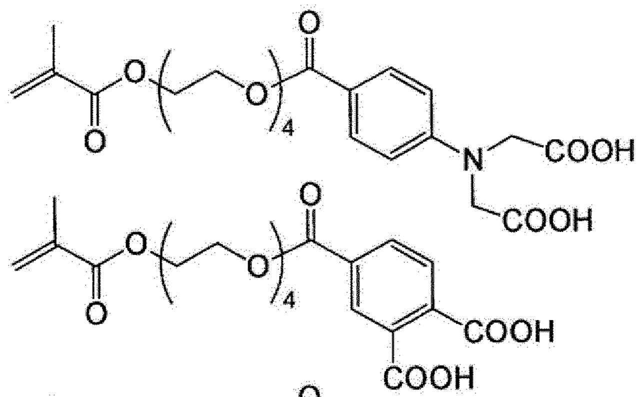

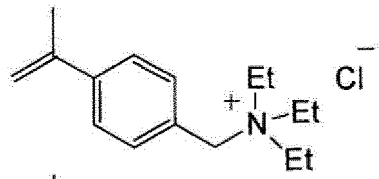

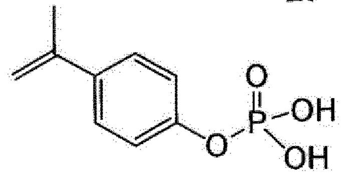

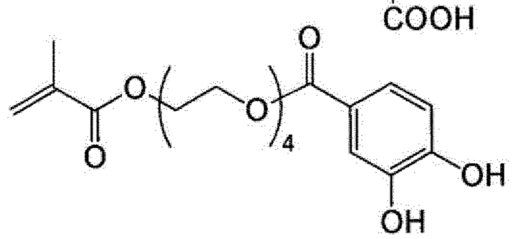

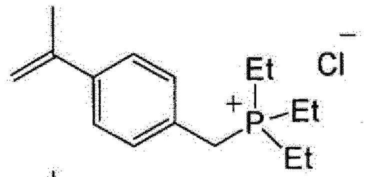

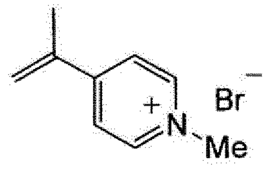

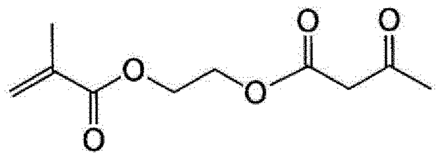

The molecular weight of the water-soluble monofunctional monomer is preferably less than 1,000, more preferably 750 or less, and still more preferably 100 or more and 500 or less.

In addition, the lithographic printing plate precursor for on-press development according to the present disclosure may contain only one type of the water-soluble monofunctional monomer, or may contain two or more types of thereof.

From the viewpoints of printing durability and on-press developability over time, the content of the water-soluble monofunctional monomer per unit area of the on-press development type lithographic printing plate precursor is preferably 1 mg/$m^2$ to 100 mg/$m^2$ and more preferably 5 mg/$m^2$ to 60 mg/$m^2$.

<Polymer having ethylenically unsaturated group>

A weight-average molecular weight of the polymer having an ethylenically unsaturated group is preferably 1,000 or more, more preferably 5,000 or more, and still more preferably 10,000 to 300,000.

In addition, a number-average molecular weight of the polymer having an ethylenically unsaturated group is preferably 1,000 or more and more preferably 2,000 to 250,000.

A polydispersity (weight-average molecular weight/number-average molecular weight) of the polymer having an ethylenically unsaturated group is preferably 1.1 to 10.

The polymer having an ethylenically unsaturated group may be any of a random polymer, a block polymer, a graft

polymer, or the like, but is preferably a random polymer.

The polymer having an ethylenically unsaturated group is preferably an addition polymerization-type resin, more preferably a polymer obtained by polymerizing with an ethylenically unsaturated bond, still more preferably an acrylic resin, and particularly preferably a polymer obtained by polymerizing at least one monomer selected from the group consisting of a (meth)acrylate compound and a (meth)acrylamide compound.

From the viewpoints of reactivity, printing durability, and on-press developability over time, the polymer having an ethylenically unsaturated group preferably has a (meth)acryl group or an allyl group, more preferably has a (meth)acryl group, and particularly preferably has a (meth)acryloxy group or a (meth)acrylamide group, as the ethylenically unsaturated group.

In addition, the polymer having an ethylenically unsaturated group is preferably a polymer having an ethylenically unsaturated group in the side chain and more preferably a polymer having a (meth)acryloxy group or a (meth)acrylamide group in the side chain.

From the viewpoints of reactivity, printing durability, and on-press developability over time, a content of the ethylenically unsaturated group (a content of a radically polymerizable unsaturated double bond as determined by iodine titration) in the polymer having an ethylenically unsaturated group is, per 1 g of the polymer having an ethylenically unsaturated group, preferably 0.1 mmol to 10.0 mmol, more preferably 1.0 mmol to 7.0 mmol, and particularly preferably 2.0 mmol to 5.5 mmol.

From the viewpoints of printing durability and on-press developability over time, the polymer having an ethylenically unsaturated group preferably has a polyalkylene oxide chain, and more preferably has a polyalkylene oxide chain in a side chain.

From the viewpoints of printing durability and on-press developability over time, the polyalkylene oxide chain is preferably a polyethylene oxide chain, a polypropylene oxide chain, or a poly(ethylene oxide/propylene oxide) chain, and more preferably a polyethylene oxide chain.

From the viewpoints of printing durability and on-press developability over time, the number of repeating alkylene oxide structures in the polyalkylene oxide chain is preferably 2 to 200, more preferably 10 to 150, and particularly preferably 20 to 100.

In addition, from the viewpoints of printing durability and on-press developability over time, the polymer having an ethylenically unsaturated group is preferably a polymer having a constitutional unit having a polyalkylene oxide chain and a constitutional unit having an ethylenically unsaturated group.

From the viewpoints of printing durability and on-press developability over time, the polymer having an ethylenically unsaturated group preferably has a support absorptive group.

A preferred aspect of the support absorptive group in the polymer having an ethylenically unsaturated group is the same as the preferred aspect of the support absorptive group in the water-soluble monofunctional monomer described above.

In addition, from the viewpoints of printing durability and on-press developability over time, the polymer having an ethylenically unsaturated group preferably has a hydrophilic group, more preferably has a support absorptive group and a hydrophilic group, and particularly preferably has a support absorptive group, a hydrophilic group, and a polyalkylene oxide chain.

As the hydrophilic group, a sulfo group or a salt thereof or a salt of a carboxy group is preferable, and a sulfo group or a salt thereof is more preferable.

In addition, the salt of a sulfo group may have a sulfobetaine structure, and from the viewpoints of printing durability and on-press developability over time, the polymer having an ethylenically unsaturated group preferably has a sulfobetaine structure.

Furthermore, from the viewpoints of printing durability and on-press developability over time, the polymer having an ethylenically unsaturated group preferably has a constitutional unit having a hydrophilic group, more preferably has a constitutional unit having a support absorptive group and a constitutional unit having a hydrophilic group, still more preferably has a constitutional unit having support absorptive group, a constitutional unit having a hydrophilic group, and a constitutional unit having a polyalkylene oxide chain, and particularly preferably has a constitutional unit having an ethylenically unsaturated group, a constitutional unit having a support absorptive group, a constitutional unit having a hydrophilic group, and a constitutional unit having a polyalkylene oxide chain.

From the viewpoints of printing durability and on-press developability over time, a content of the constitutional unit having a support absorptive group is preferably 2% by mass to 80% by mass, more preferably 5% by mass to 50% by mass, and particularly preferably 10% by mass to 40% by mass, with respect to the total mass of the polymer having an ethylenically unsaturated group.

From the viewpoints of printing durability and on-press developability over time, a content of the constitutional unit having a hydrophilic group is preferably 30% by mass to 98% by mass, more preferably 40% by mass to 90% by mass, and particularly preferably 50% by mass to 80% by mass, with respect to the total mass of the polymer having an ethylenically unsaturated group.

The lithographic printing plate precursor for on-press development according to the present disclosure may contain only one type of the polymer having an ethylenically unsaturated group, or may contain two or more types thereof.
From the viewpoints of printing durability and on-press developability over time, a content of the polymer having an ethylenically unsaturated group per unit area of the on-press development type lithographic printing plate precursor is preferably 1 mg/m$^2$ to 30 mg/m$^2$ and more preferably 5 mg/m$^2$ to 20 mg/m$^2$.
From the viewpoints of printing durability and on-press developability over time, a ratio $M^B/M^A$ of the content $M^B$ of the water-soluble monofunctional monomer to the content $M^A$ of the polymer having an ethylenically unsaturated group per unit area of the on-press development type lithographic printing plate precursor is preferably 0.8 to 10, more preferably 1.2 to 5, and particularly preferably 1.5 to 4.

<Undercoat Layer>

The on-press development type lithographic printing plate precursor according to the present disclosure preferably has an undercoat layer between the support and the image-recording layer.
From the viewpoints of printing durability and on-press developability over time, the undercoat layer preferably contains the polymer having an ethylenically unsaturated group, and more preferably contains the polymer having an ethylenically unsaturated group and the water-soluble monofunctional monomer.
Preferred aspects of the polymer having an ethylenically unsaturated group and the water-soluble monofunctional monomer, which are contained in the undercoat layer, are the same as the above-described preferred aspects.
The undercoat layer may contain only one type of water-soluble monofunctional monomer or two or more types thereof.
From the viewpoints of printing durability and on-press developability over time, a content of the water-soluble monofunctional monomer in the undercoat layer is preferably 5% by mass to 70% by mass, more preferably 10% by mass to 60% by mass, and particularly preferably 15% by mass to 40% by mass, with respect to the total mass of the undercoat layer.
The undercoat layer may contain only one type of the polymer having an ethylenically unsaturated group, or may contain two or more types thereof.
From the viewpoints of printing durability and on-press developability over time, a content of the polymer having an ethylenically unsaturated group in the undercoat layer is preferably 30% by mass to 95% by mass, more preferably 40% by mass to 90% by mass, and particularly preferably 50% by mass to 85% by mass, with respect to the total mass of the undercoat layer.
In addition, as the undercoat layer, silane coupling agents having addition polymerizable ethylenic double bond reactive groups described in JP1998-282679A (JP-H10-282679A) or a phosphorus compound having an ethylenic double bond reactive group described in JP1990-304441A (JP-H2-304441A) can also be used.
In order to prevent contamination with the passage of time, the undercoat layer may contain, a chelating agent, a secondary or tertiary amine, a polymerization inhibitor, a compound having an amino group or a functional group capable of inhibiting polymerization and a group that interacts with the surface of the support (for example, 1,4-diazabicyclo[2.2.2] octane (DABCO), 2,3,5,6-tetrahydroxy-p-quinone, chloranil, sulfophthalic acid, hydroxyethyl ethylenediaminetriacetic acid, dihydroxyethyl ethylenediaminediacetic acid, hydroxyethyl iminodiacetic acid, and the like), and the like.
In addition, the undercoat layer may contain a known additive such as a surfactant, a preservative, and the like.
The undercoat layer is applied by a known method. The coating amount (solid content) of the undercoat layer is preferably 0.1 mg/m$^2$ to 100 mg/m$^2$ and more preferably 1 mg/m$^2$ to 30 mg/m$^2$.

<Image-recording layer>

The image-recording layer contains a polymerization initiator, an infrared absorber, and an auxiliary capable of donating an electron to the infrared absorber.
The image-recording layer is preferably a negative tone image-recording layer and more preferably a water-soluble or water-dispersible negative tone image-recording layer.
In the lithographic printing plate precursor according to the present disclosure, from the viewpoint of on-press developability, a non-exposed portion of the image-recording layer is preferably removable by at least any of dampening water or printing ink.
From the viewpoint of the visibility, the image-recording layer preferably further contains an acid color forming agent.
Hereinafter, each of the components to be contained in the image-recording layer will be specifically described.
The image-recording layer may contain only one type of the water-soluble monofunctional monomer, or two or more types thereof.
From the viewpoints of printing durability and on-press developability over time, a content of the water-soluble

monofunctional monomer in the image-recording layer is preferably 1% by mass to 50% by mass, more preferably 2% by mass to 40% by mass, and particularly preferably 5% by mass to 30% by mass, with respect to the total mass of the image-recording layer.

[Polymerization initiator]

The image-recording layer in the present disclosure contains a polymerization initiator.

It is preferable that the image-recording layer contain an electron-accepting polymerization initiator as a polymerization initiator.

The electron-accepting polymerization initiator is a compound which accepts one electron by intermolecular electron migration in a case where electrons of an infrared absorber are excited by exposure to infrared rays, and generates a polymerization initiation species such as radicals.

The electron-accepting polymerization initiator used in the present disclosure is a compound that generates a polymerization initiation species such as a radical or a cation by either or both of light energy and heat energy, and can be appropriately selected from known thermal polymerization initiators, compounds having a bond that requires low bond dissociation energy, photopolymerization initiators, and the like.

As the electron-accepting polymerization initiator, a radical polymerization initiator is preferable, and an onium compound is more preferable.

In addition, as the electron-accepting polymerization initiator, an infrared-ray-sensitive polymerization initiator is preferable.

Examples of the electron-accepting radical polymerization initiator include (a) organic halide, (b) carbonyl compound, (c) azo compound, (d) organic peroxide, (e) metallocene compound, (f) azide compound, (g) hexaarylbiimidazole compound, (i) disulfone compound, (j) oxime ester compound, (k) onium compound, and the like.

As (a) organic halide, for example, the compounds described in paragraphs "0022" and "0023" of JP2008-195018A are preferable.

As (b) carbonyl compound, for example, the compounds described in paragraph "0024" of JP2008-195018A are preferable.

As (c) azo compound, for example, the azo compounds described in JP1996-108621A (JP-H8-108621A) and the like can be used.

As (d) organic peroxide, for example, the compounds described in paragraph "0025" of JP2008-195018A are preferable.

As (e) metallocene compound, for example, the compounds described in paragraph "0026" of JP2008-195018A are preferable.

Examples of (f) azide compound can include compounds such as 2,6-bis(4-azidobenzylidene)-4-methylcyclohexanone.

As (g) hexaarylbiimidazole compound, for example, the compounds described in paragraph "0027" of JP2008-195018A are preferable.

Examples of (i) disulfone compound include the compounds described in JP1986-166544A (JP-S61-166544A) and JP2002-328465A.

As (j) oxime ester compound, for example, the compounds described in paragraphs "0028" to "0030" of JP2008-195018A are preferable.

Among the above-described electron-accepting polymerization initiators, an oxime ester compound and an onium compound are preferable from the viewpoint of the curability. Particularly, from the viewpoint of printing durability, an iodonium salt compound, a sulfonium salt compound, or an azinium salt compound is preferable, an iodonium salt compound or a sulfonium salt compound is more preferable, and an iodonium salt compound is particularly preferable.

Specific examples of these compounds will be shown below, but the present disclosure is not limited thereto.

As the iodonium salt compound, for example, a diaryliodonium salt compound is preferable. Particularly, an electron-donating group, for example, a diphenyl iodonium salt compound substituted with an electron-donating group such as an alkyl group or an alkoxyl group is more preferable. In addition, an asymmetric diphenyl iodonium salt compound is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=-tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=hexafluorophosphate, and bis(4-t-butylphenyl)iodonium=hexafluorophosphate.

As the sulfonium salt compound, for example, a triarylsulfonium salt compound is preferable. Particularly, a triarylsulfonium salt compound is preferable in which at least some of electron-withdrawing groups such as groups on an aromatic ring are substituted with halogen atoms, and a triarylsulfonium salt compound is more preferable in which the total number of halogen atoms as substituents on an aromatic ring is 4 or more. Specific examples thereof include

triphenylsulfonium=hexafluorophosphate, triphenylsulfonium=benzoyl formate, bis(4-chlorophenyl)phenylsulfonium=-benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, and tris(2,4-dichlorophenyl)sulfonium=hexafluorophosphate.

As a counteranion of the iodonium salt compound and the sulfonium salt compound, a sulfonamide anion or a sulfonimide anion is preferable, and a sulfonimide anion is more preferable.

As the sulfonamide anion, an aryl sulfonamide anion is preferable.

In addition, as the sulfonimide anion, a bisaryl sulfonimide anion is preferable.

Specifically, suitable examples of the sulfonamide anion and the sulfonimide anion include those described in WO2020/262692A.

From the viewpoint of developability and printing durability of the lithographic printing plate to be obtained, the electron-accepting polymerization initiator may include a compound represented by Formula (Su).

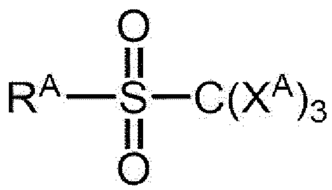

( Su )

In Formula (Su), $X^A$ represents a halogen atom, and $R^A$ represents an aryl group.

Specifically, examples of $X^A$ in Formula (Su) include a fluorine atom, a chlorine atom, a bromine atom, and an iodine atom. Among these, a chlorine atom or a bromine atom is preferable because these have excellent sensitivity, and a bromine atom is particularly preferable.

Furthermore, from the viewpoint of excellent balance between sensitivity and storage stability, $R^A$ in Formula (Su) is preferably an aryl group substituted with an amide group.

As a specific example of the electron-accepting polymerization initiator represented by Formula (Su), those described in WO2020/262692A can be suitably used.

From the viewpoints of improving sensitivity and making it difficult for plate missing to occur, the lowest unoccupied molecular orbital (LUMO) of the polymerization initiator is preferably -3.00 eV or less, and more preferably -3.02 eV or less.

The lower limit of LUMO is preferably -3.80 eV or more and more preferably -3.60 eV or more.

The polymerization initiators may be used alone or in combination of two or more types thereof.

The content of the polymerization initiator with respect to the total mass of the image-recording layer is preferably 0.1% by mass to 50% by mass, more preferably 0.5% by mass to 30% by mass, and particularly preferably 0.8% by mass to 20% by mass.

[Infrared absorber]

The lithographic printing plate precursor according to the present disclosure contains an infrared absorber in an image-recording layer.

The infrared absorber is not particularly limited, and examples thereof include pigments and dyes.

As the dye that is used as the infrared absorber, it is possible to use commercially available dyes and known dyes described in publications, for example, "Dye Handbooks" (edited by the Society of Synthetic Organic Chemistry, Japan, 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among these dyes, for example, a cyanine colorant, a squarylium colorant, a pyrylium salt, a nickel thiolate complex, and an indolenine cyanine colorant are particularly preferable. Furthermore, for example, a cyanine colorant or an indolenine cyanine colorant is preferable. Among these, a cyanine colorant is particularly preferable.

The infrared absorber is preferably a cationic polymethine colorant having an oxygen or nitrogen atom at the meso-position. Preferred examples of the cationic polymethine colorant include a cyanine colorant, a pyrylium colorant, a thiopyrylium colorant, an azulenium colorant, and the like. From the viewpoint of ease of availability, solubility in a solvent during an introduction reaction, and the like, a cyanine colorant is preferable.

Specific examples of the cyanine colorant include the compounds described in paragraphs "0017" to "0019" of JP2001-133969A and the compounds described in paragraphs "0016" to "0021" of JP2002-023360A and paragraphs "0012" to "0037" of JP2002-040638A. As the cyanine colorant, for example, the compounds described in paragraphs "0034" to "0041" of JP2002-278057A and paragraphs "0080" to "0086" of JP2008-195018A are preferable, and the

compounds described in paragraphs "0035" to "0043" of JP2007-90850A and the compounds described in paragraphs "0105" to "0113" of JP2012-206495A are particularly preferable.

In addition, the compounds described in paragraphs "0008" and "0009" of JP1993-5005A (JP-H05-5005A) and paragraphs "0022" to "0025" of JP2001-222101A can also be preferably used.

As pigments, the compounds described in paragraphs "0072" to "0076" of JP2008-195018A are preferable.

The aforementioned infrared absorber preferably includes, for example, an infrared absorber that decomposes due to exposure to infrared (decomposition-type infrared absorber), and more preferably includes a decomposing and color-forming infrared absorber.

Presumably, in a case where a decomposition-type infrared absorber is used as the aforementioned infrared absorber, the infrared absorber or a decomposition product thereof may promote polymerization, and the decomposition product of the infrared absorber and the polymerizable compound may interact with each other, which may result in excellent printing durability.

The decomposition-type infrared absorber is preferably an infrared absorber that has a function of forming color by absorbing infrared and decomposing by exposure to infrared.

Hereinafter, a color-forming compound formed as a result of infrared absorption and decomposition of the decomposition-type infrared absorber by exposure to infrared rays will be also called "color forming substance of the decomposition-type infrared absorber".

In addition, it is preferable that the decomposition-type infrared absorber has a function of absorbing infrared rays by exposure to infrared rays and converting the absorbed infrared rays into heat.

The decomposition-type infrared absorber may be an infrared absorber that decomposes by absorbing at least a part of light in the infrared wavelength region (wavelength of 750 nm to 1 mm). The decomposition-type infrared absorber is preferably an infrared absorber having a maximal absorption wavelength in a wavelength region of 750 nm to 1,400 nm, and more preferably an infrared absorber having a maximal absorption wavelength in a wavelength region of 760 nm to 900 nm.

More specifically, the decomposition-type infrared absorber is preferably a compound that decomposes upon the exposure to infrared and generates a compound having maximal absorption wavelength in a wavelength region of 500 nm to 600 nm.

The decomposition-type infrared absorber is preferably an infrared absorber that decomposes by either or both of heat and electron migration resulting from exposure to infrared rays, and more preferably an infrared absorber that decomposes by electron migration resulting from exposure to infrared rays. "Decomposes by electron migration" mentioned herein means that electrons excited to the lowest unoccupied molecular orbital (LUMO) from the highest occupied molecular orbital (HOMO) of the decomposition-type infrared absorber by exposure to infrared rays move to electron accepting groups (groups having potential close to LUMO) in a molecule by means of intramolecular electron migration and thus result in decomposition.

As the infrared absorber and the infrared absorber that decomposes by exposure to infrared, those described in WO2020/262692A can also be suitably used.

As the infrared absorber that decomposes by exposure to infrared, those described in JP2008-544322A or WO2016/027886A can also be suitably used.

In addition, as the cyanine colorant which is a decomposition-type infrared absorber, the infrared absorbing compounds described in WO2019/219560A can be suitably used.

From the viewpoints of printing durability and halftone dot reproducibility, the highest occupied molecular orbital (HOMO) value of the infrared absorber used in the present disclosure is preferably -5.00 eV or less and more preferably -5.30 eV or less.

From the viewpoints of printing durability and halftone dot reproducibility, the lower limit of HOMO of the infrared absorber is preferably -5.90 eV or more, more preferably -5.75 eV or more, and even more preferably -5.60 eV or more.

In the present disclosure, the energy of molecular orbital (MO) such as the highest occupied molecular orbital (HOMO) and the lowest unoccupied molecular orbital (LUMO) is calculated by the following methods.

First, free counter ions in the compound as a calculation object are excluded from the calculation object. For example, for a cationic one-electron-accepting polymerization initiator and a cationic infrared absorber, counteranions are excluded from the calculation object, and for an auxiliary capable of donating an electron to an anionic one-electron-donating polymerization initiator, countercations are excluded from the calculation object. "Free" mentioned herein means that the compound as an object and the counter ions thereof are not covalently linked to each other.

The structural optimization is carried out by DFT (B3LYP/6-31G(d)) using quantum chemical calculation software Gaussian 16.

The MO energy is calculated by DFT (B3LYP/6-31+G(d,p)/PCM (solvent = methanol)) with the optimum structure obtained by the structural optimization, using quantum chemical calculation software Gaussian 16. For an iodine-containing compound, the MO energy is calculated under the condition of DFT (B3LYP/DGDZVP/PCM (solvent = methanol)).

The optimum structure mentioned herein means a structure in which the total energy obtained by DFT calculation is the most stable. The most stable structure is found by repeating the structural optimization as necessary.

By the following formula, the MO energy Ebare (unit: hartree) obtained by the above-described MO energy calculation is converted into Escaled (unit: eV) used as the values of HOMO and LUMO in the present disclosure.

$$[\text{Calculation formula for HOMO}]\ \text{Escaled} = 0.823168 \times 27.2114 \times \text{Ebare} - 1.07634$$

$$[\text{Calculation formula for LUMO}]\ \text{Escaled} = 0.820139 \times 27.2114 \times \text{Ebare} - 1.086039$$

27.2114 is simply a coefficient for converting hartree into eV, and 0.823168 and -1.07634 used for calculating HOMO and 0.820139 and -1.086039 used for calculating UMO are adjustment coefficients. These are determined such that the calculated values of HOMO and LUMO of the compound as a calculation object match the measured values.

Only one infrared absorber may be used, or two or more infrared absorbers may be used in combination. In addition, as the infrared absorber, a pigment and a dye may be used in combination.

The total content of the infrared absorber in the image-recording layer with respect to the total mass of the image-recording layer is preferably 0.1% by mass to 10.0% by mass, and more preferably 0.5% by mass to 5.0% by mass.

[Color forming substance precursor]

The image-recording layer contains a color forming substance precursor.

From the viewpoint of color formability, the color forming substance precursor preferably includes an acid color forming agent. In addition, from the viewpoint of color formability, the color forming substance precursor preferably includes a leuco compound.

"Color forming substance precursor" used in the present disclosure means a compound having properties that form color by a stimulus such as light or acid and thus change the color of the image-recording layer. Furthermore, "acid color forming agent" means a compound having properties that form color by being heated in a state of receiving an electron accepting compound (for example, a proton of an acid or the like) and thus change the color of the image-recording layer. The acid color forming agent is particularly preferably a colorless compound which has a partial skeleton such as lactone, lactam, sultone, spiropyran, an ester, or an amide and allows such a partial skeleton to rapidly open the ring or to be cleaved when coming into contact with an electron-accepting compound.

From the viewpoint of UV printing durability, the hydrogen abstraction enthalpy of all hydrogen atoms present in a molecule of the color forming substance precursor is preferably -6.5 kcal/mol or more, more preferably -4.0 kcal/mol or more, even more preferably -2.0 kcal/mol or more, and particularly preferably -2.0 kcal/mol to 50 kcal/mol.

The higher the hydrogen abstraction enthalpy, the further the hydrogen atoms are inhibited from being abstracted from the color forming substance precursor by a polymerization initiation species such as radicals, and the further the polymerization reaction is prolonged. Therefore, curability are excellent, and printing durability, particularly, UV printing durability is further improved.

In the present disclosure, the hydrogen abstraction enthalpy of all hydrogen atoms presents in a molecule of the color forming substance precursor is calculated by the following method.

Regarding a reaction with propagating radicals caused by hydrogen abstraction, the enthalpy of each of the reactant and product is calculated using Gaussian 16 as a calculation program at a calculation level of density functional theory (B3LYP/6-31+G**). The solvent effect (solvent: methanol) is examined by the SCRF method. By finding the difference in the enthalpy between the reactant and the product, a reaction enthalpy is calculated.

More specifically, the hydrogen abstraction enthalpy is calculated as follows. In the following chemical reaction formula, for each of the propagating radical, LeucoDye-H, the hydrogenated propagating radical, and LeucoDye-radical, modeling is carried out using Gaussian pre/post software GaussView6. #p opt b31yp/6-31+g (d, p) scrf = (solvent = methanol) is specified as a calculation condition, charge 0 multiplicity 2 is set for the radical, and charge 0 multiplicity 1 is set for substances other than the radical. #p is specified for detailed logging output, and may not be specified.

From the energy (unit: hartree) of the structure optimized by performing calculation, the enthalpy of formation of the reactant (sum of the energy of the propagating radical and LeucoDye-H) and the enthalpy of formation of the product (sum of the energy of the hydrogenated propagating radical and LeucoDye-radical) are calculated. The enthalpy of formation of the reactant is subtracted from the enthalpy of formation of the product, and the result is adopted as the hydrogen abstraction enthalpy. The unit is converted as 1 hartree = 627.51 kcal/mol.

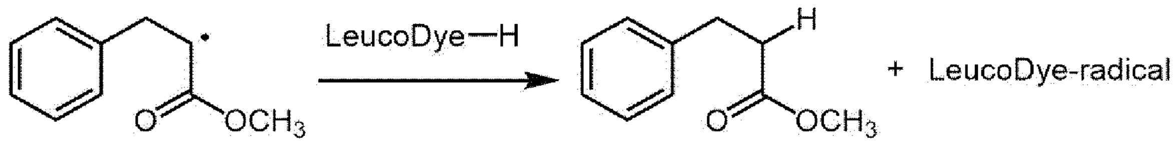


For example, the hydrogen abstraction enthalpy for each hydrogen atom of the following compound is as follows.

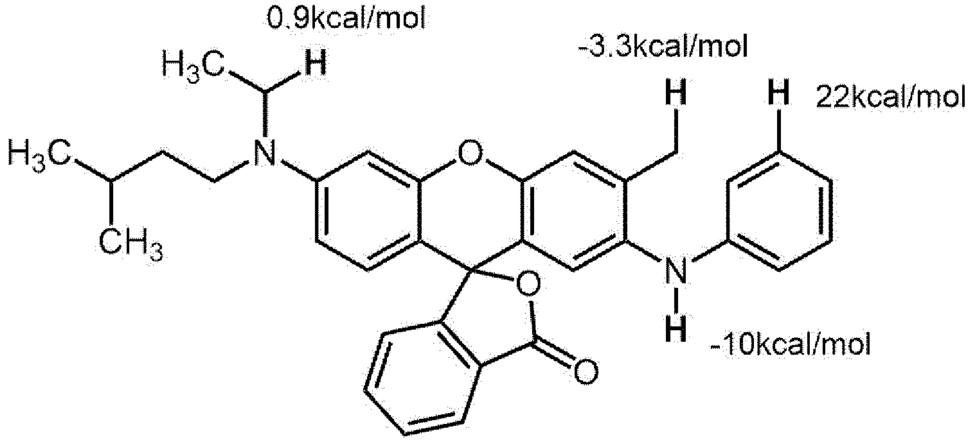


From the viewpoint of UV printing durability, it is preferable that the color forming substance precursor does not have a structure in which a hydrogen atom is directly bonded to a nitrogen atom.

The structure in which a hydrogen atom is directly bonded to a nitrogen atom (N-H structure) is a structure in which a hydrogen abstraction reaction is likely to occur by a radical or the like. In a case where the color forming substance precursor is a compound that does not have such a structure, the hydrogen atom abstraction from the color forming substance precursor is inhibited, and the polymerization reaction is prolonged. Therefore, excellent curability is obtained, and printing durability, particularly, UV printing durability is further improved.

Particularly, from the viewpoint of color formability, the color forming agent used in the present disclosure is preferably at least one type of compound selected from the group consisting of a spiropyran compound, a spirooxazine compound, a spirolactone compound, and a spirolactam compound.

From the viewpoint of visibility, the hue of the colorant after color forming is preferably green, blue, or black.

From the viewpoint of color formability and visibility of exposed portions, the acid color forming agent is preferably a leuco colorant.

The aforementioned leuco colorant is not particularly limited as long as it has a leuco structure. The leuco colorant preferably has a spiro structure, and more preferably has a spirolactone ring structure.

From the viewpoint of color formability and visibility of exposed portions, the leuco colorant is preferably a leuco colorant having a phthalide structure or a fluoran structure.

From the viewpoints of visibility, UV printing durability, and temporal stability, the color forming substance precursor preferably has 2 or more electron-donating groups directly bonded to an aromatic ring.

As the electron-donating groups, from the viewpoints of color formability and visibility of the exposed portion, an amino group, an alkylamino group, an arylamino group, a dialkylamino group, a monoalkyl monoarylamino group, a diarylamino group, an alkoxy group, an aryloxy group or an alkyl group is preferable, an amino group, alkylamino group, arylamino group, dialkylamino group, monoalkyl monoarylamino group, diarylamino group, alkoxy group, or an aryloxy group is more preferable, a monoalkyl monoarylamino group or a diarylamino group is even more preferable, and a monoalkyl monoarylamino group is particularly preferable.

From the viewpoint of visibility, UV printing durability, and temporal stability, the color forming substance precursor preferably has a xanthene structure.

Furthermore, from the viewpoint of visibility, UV printing durability, and temporal stability, the color forming substance precursor preferably includes a compound represented by Formula (Z-1) or Formula (Z-2), and more preferably includes a compound represented by Formula (Z-1).

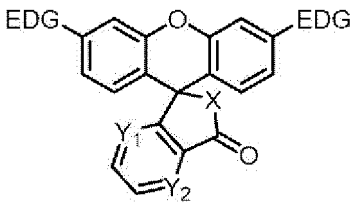

(Z-1)

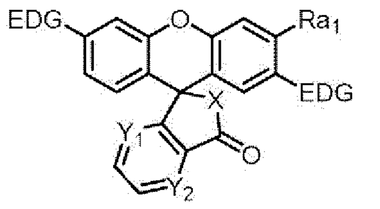

(Z-2)

In Formula (Z-1) and Formula (Z-2), EDG each independently represents an electron-donating group, X represents O or NR, R represents a hydrogen atom, an alkyl group, an aryl group, or a heteroaryl group, $Y_1$ and $Y_2$ each independently represent CH or N, and $Ra_1$ represents a hydrogen atom, an alkyl group, or an alkoxy group.

As the electron-donating groups represented by EDG in Formula (Z-1) and Formula (Z-2), from the viewpoints of color formability and visibility of the exposed portion, an amino group, an alkylamino group, an arylamino group, a dialkylamino group, a monoalkyl monoarylamino group, a diarylamino group, an alkoxy group, an aryloxy group or an alkyl group is preferable, an amino group, alkylamino group, arylamino group, dialkylamino group, monoalkyl monoarylamino group, diarylamino group, alkoxy group, or an aryloxy group is more preferable, a monoalkyl monoarylamino group or a diarylamino group is even more preferable, and a monoalkyl monoarylamino group is particularly preferable.

Furthermore, from the viewpoint of visibility, UV printing durability, and temporal stability, the color forming substance precursor more preferably includes a compound represented by Formula (Z-3) or Formula (Z-4), and particularly preferably includes a compound represented by Formula (Z-3).

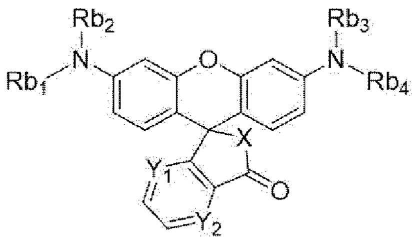

(Z-3)

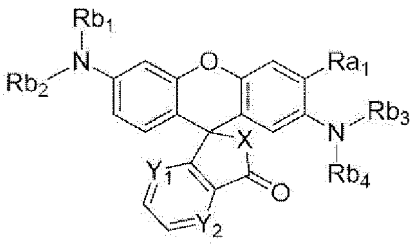

(Z-4)

In Formula (Z-3) and Formula (Z-4), $Ra_1$ represents a hydrogen atom, an alkyl group, or an alkoxy group, $Rb_1$ to $Rb_4$ each independently represent a hydrogen atom, an alkyl group, or an aryl group, $Rb_1$ and $Rb_2$ or $Rb_3$ and $Rb_4$ may form a ring, and $Y_1$ and $Y_2$ each independently represent CH or N.

From the viewpoints of visibility, UV printing durability, and temporal stability, $Rb_1$ and $Rb_4$ in Formula (Z-3) and Formula (Z-4) preferably each independently represent an alkyl group or an aryl group, and more preferably each independently represent an aryl group.

From the viewpoints of visibility, UV printing durability, and temporal stability, $Rb_2$ and $Rb_3$ in Formula (Z-3) and Formula (Z-4) preferably each independently represent an alkyl group or an aryl group, and more preferably each independently represent an alkyl group.

From the viewpoints of visibility, UV printing durability, and temporal stability, $Rb_1$ and $Rb_4$ in Formula (Z-3) and Formula (Z-4) preferably each independently represent a hydrogen atom or an alkoxy group, and more preferably each independently represent a hydrogen atom.

In Formula (Le-A) and Formula (Le-B), from the viewpoint of color formability and visibility of the exposed portion, $X_1$ to $X_4$ preferably each represent a hydrogen atom, and $Y_1$ and $Y_2$ preferably each represent C.

The alkyl group in Formula (Z-1) to Formula (Z-4) may be linear or branched or may have a ring structure.

The number of carbon atoms in the alkyl group in Formula (Z-1) to Formula (Z-4) is preferably 1 to 20, more preferably 1 to 8, even more preferably 1 to 4, and particularly preferably 1 or 2.

The number of carbon atoms in the aryl group in Formula (Z-1) to Formula (Z-4) is preferably 6 to 20, more preferably 6 to 10, and particularly preferably 6 to 8.

Furthermore, each of the groups such as the alkyl group and the aryl group in Formula (Z-1) to Formula (Z-4) may have a substituent. Examples of the substituent include an alkyl group, an aryl group, a halogen atom, an amino group, an alkylamino group, an arylamino group, a dialkylamino group, a monoalkyl monoarylamino group, a diarylamino group, a hydroxy group, an alkoxy group, an aryloxy group, an acyl group, an alkoxycarbonyl group, an aryloxycarbonyl group, a cyano group, and the like. In addition, these substituents may be further substituted with these substituents.

From the viewpoint of visibility, a molar absorption coefficient ε of a color forming substance generated from the

color forming substance precursor is preferably 35,000 or more, more preferably 35,000 or more and 200,000 or less, and particularly preferably 50,000 or more and 150,000 or less.

In the present disclosure, the molar absorption coefficient ε of the color forming substance generated from the color forming substance precursor is measured by the following method.

The color forming substance precursor to be measured is weighed (0.04 mmol) and put in a 100 mL volumetric flask.

Acetic acid (about 90 mL) is added thereto. After it is visually confirmed that the measurement sample has completely dissolved,

acetic acid is added thereto such that the volume increases up to 100 mL, thereby preparing a dye solution A.

Acetic acid (about 80 mL) is added to another 100 mL volumetric flask, 5 mL of ion exchanged water and 5 mL of the dye solution A are then added thereto by using a 5 mL transfer pipette, and the solution is gently shaken.

After it is visually confirmed that the solution has no precipitate of the color forming substance precursor, acetic acid is added thereto so that the volume increases up to 100 mL, thereby preparing a dye solution B. In the dye solution B, the concentration of the color forming substance precursor is 0.02 mmol/L.

A measurement cell (quartz glass, optical path width: 10 mm) is filled with the dye solution B, and the solution is measured using an ultraviolet-visible spectrophotometer (UV-1800, manufactured by Shimadzu Corporation.).

As a blank, a solution of water:acetic acid = 5:95 is used.

From the obtained spectrum, the maximal absorption wavelength in the visible light region (380 nm to 750 nm) is read. From the absorbance at the wavelength, the molar absorption coefficient ε is calculated.

From the viewpoint of visibility, a ring-opening ratio of the color forming substance precursor calculated by the following equation is preferably 15% or more and 100% or less, more preferably 40% or more and 99% or less, even more preferably 60% or more and 99% or less, particularly preferably 75% or more and 99% or less, and most preferably 85% or more and 99% or less.

Ring-opening ratio = molar absorption coefficient of the color forming substance obtained in case of adding 1 molar equivalent of acid to the color forming substance precursor/molar absorption coefficient ε of the color forming substance generated from the color forming substance precursor × 100

From the viewpoint of visibility, in the visible light region (380 nm to 750 nm), the maximum absorption wavelength λmax of the color forming substance generated from the color forming substance precursor is preferably 500 nm to 650 nm, more preferably 520 nm to 600 nm, even more preferably 530 nm to 580 nm, and particularly preferably 540 nm to 570 nm.

In the present disclosure, the ring-opening ratio and λmax are measured by the following methods.

-Preparation of dye solution C-

The color forming substance precursor is weighed (0.1 mmol) and put in a 50 mL volumetric flask.

About 40 mL of acetonitrile is added thereto. After it is visually confirmed that the measurement sample has completely dissolved, acetonitrile is added thereto such that the volume increases up to 50 mL, thereby preparing a dye solution C.

-Preparation of acid solution D-

0.2 mmol of 10-camphorsulfonic acid (CSA) is added to a 100 mL volumetric flask, and about 80 mL of acetonitrile is added thereto. After it is confirmed that CSA has completely dissolved, acetonitrile is added thereto such that the volume increases up to 100 mL, thereby preparing an acid solution D.

-Preparation of measurement solution E-

5 mL of ion exchanged water is added to a 100 mL volumetric flask by using a transfer pipette, and 80 mL of acetonitrile is added thereto. 1 mL of the dye solution C and 1 mL of the acid solution D are added thereto, and the volume increases up to 100 mL, thereby preparing a measurement solution E.

In the measurement E, the concentration of the color forming substance precursor including the generated color forming substance is 0.02 mmol/L.

A measurement cell (quartz glass, optical path width: 10 mm) is filled with the dye solution E, and the solution is measured using an ultraviolet-visible spectrophotometer (UV-1800, manufactured by Shimadzu Corporation.).

As a blank, a solution of water: acetonitrile = 5:95 is used.

From the obtained spectrum, the maximal absorption wavelength λmax in the visible light region (380 nm to 750 nm) is read. From the absorbance at the wavelength, the molar absorption coefficient ε is calculated.

The ring-opening ratio is calculated according to the following equation.

Ring-opening ratio = molar absorption coefficient of the color forming substance obtained in case of adding 1 molar equivalent of acid to the color forming substance precursor/molar absorption coefficient ε of the color forming substance generated from the color forming substance precursor × 100

As the color forming substance precursor to be used, for example, the following compounds are suitable. Me represents a methyl group, Et represents an ethyl group, Bu represents a butyl group, Oct represents an octyl group, and Ph represents a phenyl group.

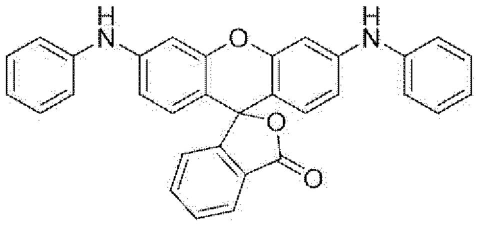

S-1

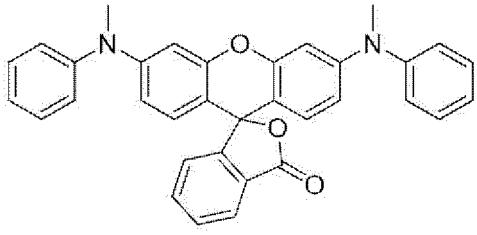

S-2

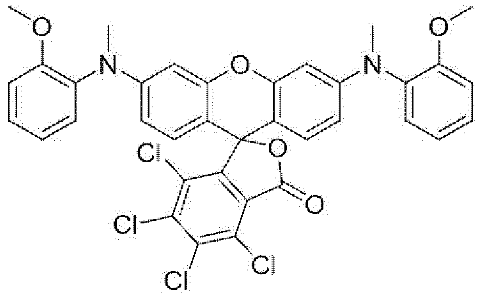

S-3

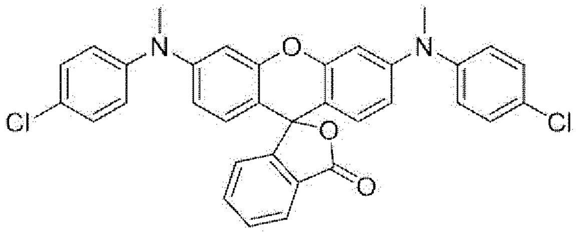

S-4

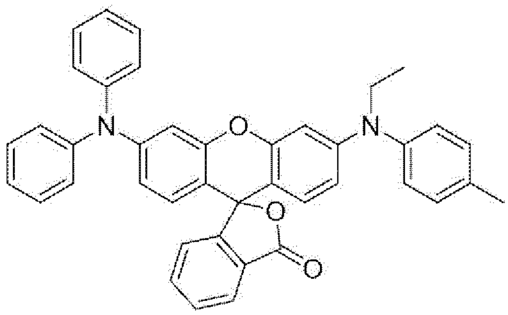

S-5

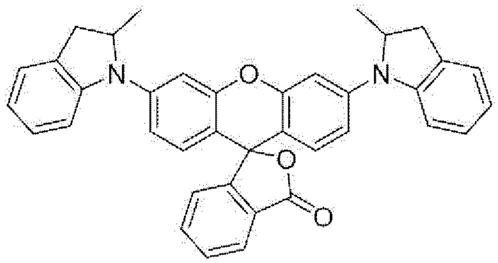

S-6

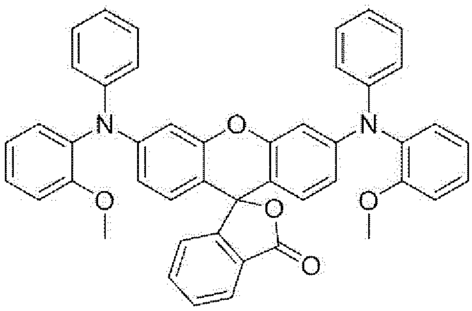

S-7

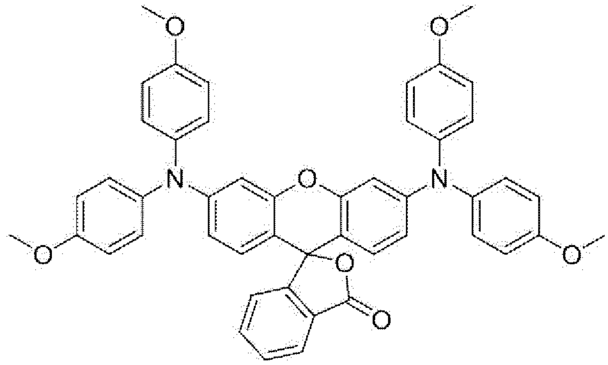

S-8

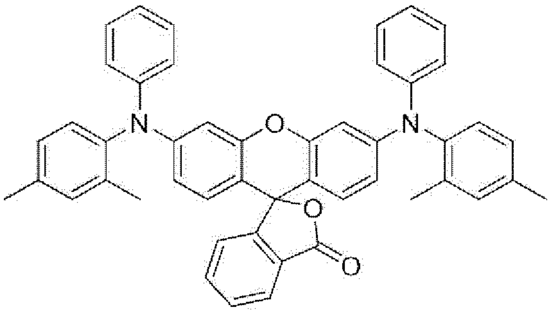

S-9

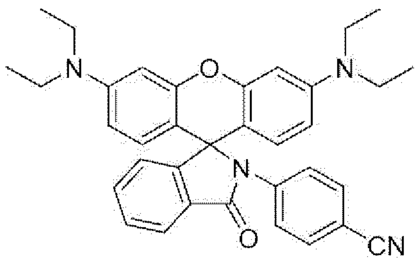

S-10

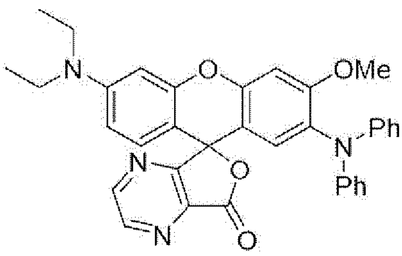

S-11

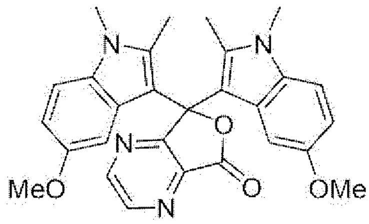

S-12

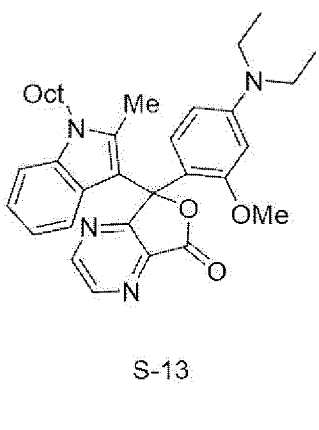

S-13

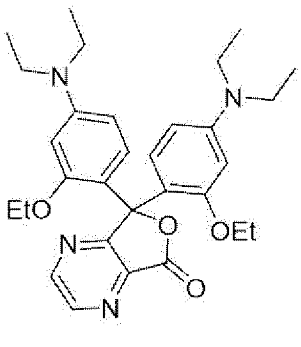

S-14

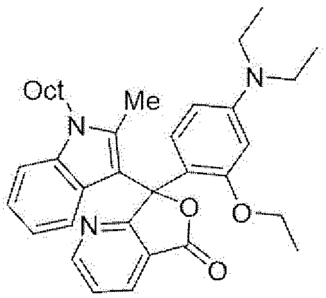

S-15

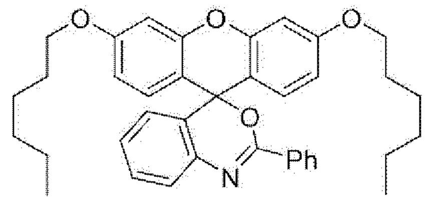

S-16

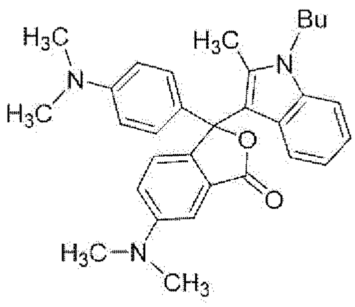

S-17

One of these color forming substance precursors may be used alone, or two or more of these components can be used in combination.

The content of the color forming substance precursor with respect to the total mass of the image-recording layer is preferably 0.5% by mass to 10% by mass, and more preferably 1% by mass to 5% by mass.

[Auxiliary capable of donating electron to above-described infrared absorber]

The auxiliary capable of donating an electron to the infrared absorber may be a compound capable of donating an electron to the infrared absorber, and examples thereof include the following five types.

(i) Alkyl- or aryl-ate complex: considered to generate active radicals by oxidative cleavage of carbon-hetero bond. Specific examples thereof include a borate compound.
(ii) Amino acetate compound: considered to generate active radicals by oxidation-induced cleavage of C-X bond on carbon adjacent to nitrogen. X is preferably a hydrogen atom, a carboxy group, a trimethylsilyl group, or a benzyl group. Specific examples thereof include N-phenylglycines (which may have a substituent in a phenyl group.), N-phenyl iminodiacetic acids (which may have a substituent in a phenyl group), and the like.
(iii) Sulfur-containing compound: compound obtained by substituting nitrogen atoms of the aforementioned amino acetate compound with sulfur atoms and capable of generating active radicals by the same action as that of the amino acetate compound. Specific examples thereof include phenylthioacetic acids (which may have a substituent on a phenyl group) and the like.
(iv) Tin-containing compound: compound obtained by substituting nitrogen atoms of the aforementioned amino acetate compound with tin atoms and capable of generating active radicals by the same action as that of the amino acetate compound.
(v) Sulfinates: capable of generating active radicals by oxidation. Specific examples thereof include sodium aryl sulfinate and the like.

Among these, from the viewpoints of printing durability and sensitivity, the auxiliary capable of donating an electron to the infrared absorber is preferably a borate compound. The borate compound is preferably a tetraaryl borate compound or a monoalkyltriaryl borate compound, from the viewpoint of compound stability, more preferably a tetraaryl borate compound, and particularly preferably a tetraphenyl borate compound.

The countercation that the borate compound has is not particularly limited, but is preferably an alkali metal ion or a tetraalkyl ammonium ion and more preferably a sodium ion, a potassium ion, or a tetrabutylammonium ion.

Specifically, preferred examples of the borate compound include sodium tetraphenyl borate.

In addition, from the viewpoints of chemical resistance and printing durability, the highest occupied molecular orbital (HOMO) of the auxiliary capable of donating an electron to the infrared absorber is preferably -6.00 eV or more, more preferably -5.95 eV or more, even more preferably -5.93 eV or more, and particularly preferably more than -5.90 eV

The upper limit of HOMO is preferably -5.00 eV or less and more preferably -5.40 eV or less.

Hereinafter, specifically, preferred examples of the auxiliary capable of donating an electron to the infrared absorber suitably include the electron-donating polymerization initiator described in WO2020/262692A.

From the viewpoints of visibility, printing durability, and temporal stability, the image-recording layer preferably contains at least one compound selected from the group consisting of an onium compound as the polymerization initiator and a borate compound as an auxiliary capable of donating an electron to the infrared absorber, and more preferably contains an onium compound as the polymerization initiator and a borate compound as an auxiliary capable of donating an electron to the infrared absorber.

In addition, the image-recording layer preferably contains a borate compound as the auxiliary capable of donating an electron to the infrared absorber, and it is more preferable that the image-recording layer contains a borate compound as the auxiliary capable of donating an electron to the infrared absorber and the HOMO value of the infrared absorber - the HOMO value of the borate compound is 0.70 eV or less.

Only one type of the auxiliary capable of donating an electron to the infrared absorber may be added to the image-recording layer, or two or more types thereof may be used in combination.

The content of the auxiliary capable of donating an electron to the infrared absorber is preferably 0.01% by mass to 30% by mass, more preferably 0.05% by mass to 25% by mass, and still more preferably 0.1% by mass to 20% by mass, with respect to the total mass of the image-recording layer.

In addition, one of the preferred aspects in the present disclosure is an aspect in which the polymerization initiator and an auxiliary capable of donating an electron to the infrared absorber form a salt.

Specific examples thereof include an aspect in which the onium compound is a salt of an onium ion and an anion (for example, a tetraphenylborate anion) in an auxiliary capable of donating an electron to the infrared absorber. In addition, more preferably, examples thereof include an iodonium borate salt compound in which an iodonium cation (for example, a di-p-tolyl iodonium cation) in the iodonium salt compound and a borate anion in the auxiliary capable of donating an electron to the infrared absorber form a salt.

Specifically, suitable examples of the aspect in which the polymerization initiator and the auxiliary capable of donating an electron to the infrared absorber form a salt include those described in WO2020/262692A.

In the present disclosure, in a case where the image-recording layer contains the onium ion and an anion in the auxiliary capable of donating an electron to the infrared absorber, the image-recording layer contains the polymerization initiator and the auxiliary capable of donating an electron to the infrared absorber.

[Relationship among auxiliary capable of donating electron to infrared absorber, polymerization initiator, and infrared absorber, which are described above]

The image-recording layer in the present disclosure contains the auxiliary capable of donating an electron to the infrared absorber, the polymerization initiator, and the infrared absorber, and it is preferable that HOMO of the auxiliary capable of donating an electron to the infrared absorber is -6.0 eV or more and LUMO of the polymerization initiator is -3.0 eV or less.

More preferred aspects of the HOMO of the auxiliary capable of donating an electron to the infrared absorber and the LUMO of the polymerization initiator are each as described above.

In the image-recording layer in the present disclosure, it is presumed that at least one type of the auxiliary capable of donating an electron to the infrared absorber, and the infrared absorber, and the polymerization initiator transfer energy to each other.

Therefore, it is considered that in a case where the HOMO of the auxiliary capable of donating an electron to the infrared absorber is -6.0 eV or more and the LUMO of the polymerization initiator is -3.0 eV or less, the generation efficiency of radicals is improved, and thus chemical resistance and printing durability are likely to be more excellent.

From the viewpoints of printing durability and chemical resistance, the HOMO value of the infrared absorber - the HOMO value of the auxiliary capable of donating an electron to the infrared absorber is preferably 1.0 eV or less, more preferably 0.70 eV or less, and particularly preferably 0.60 eV or less. In addition, from the same viewpoints as above, the HOMO value of the infrared absorber - the HOMO value of the auxiliary capable of donating an electron to the infrared absorber is preferably -0.200 eV or more and more preferably -0.100 eV or more. The negative value means that the HOMO of the auxiliary capable of donating an electron to the infrared absorber is higher than the HOMO of the infrared absorber.

In addition, from the viewpoint of printing durability and chemical resistance, the LUMO value of the polymerization initiator - the LUMO value of the infrared absorber is preferably 1.00 eV or less, and more preferably 0.700 eV or less.

Furthermore, from the same viewpoints as above, the LUMO value of the polymerization initiator - the LUMO value of the infrared absorber is preferably -0.200 eV or more and more preferably -0.100 eV or more.

In addition, from the same viewpoints as above, the LUMO value of the polymerization initiator - the LUMO value of the infrared absorber is preferably in a range of 1.00 eV to -0.200 eV and more preferably in a range of 0.700 eV to -0.100 eV The negative value means that LUMO of the infrared absorber is higher than LUMO of the polymerization initiator.

[Polymerizable compound]

It is preferable that the image-recording layer in the present disclosure contain a polymerizable compound.

In the present disclosure, a polymerizable compound refers to a compound having a polymerizable group.

The polymerizable group is not particularly limited, may be a known polymerizable group, and is preferably an ethylenically unsaturated group. In addition, the polymerizable group may be a radically polymerizable group or a cationically polymerizable group, and is preferably a radically polymerizable group.

Examples of the radically polymerizable group include a (meth)acryloyl group, an allyl group, a vinylphenyl group, a vinyl group, and the like. From the viewpoint of reactivity, a (meth)acryloyl group is preferable.

The molecular weight of the polymerizable compound (weight-average molecular weight in a case where the polymerizable compound has molecular weight distribution) is preferably 50 or more and less than 2,500.

The polymerizable compound used in the present disclosure may be, for example, a radically polymerizable compound or a cationically polymerizable compound, and is preferably an addition polymerizable compound having at least one ethylenically unsaturated bond (ethylenically unsaturated compound).

The ethylenically unsaturated compound is preferably a compound having at least one terminal ethylenically unsaturated bond, and more preferably a compound having two or more terminal ethylenically unsaturated bonds. The chemical form of the polymerizable compound is, for example, a monomer, a prepolymer that is a dimer, a trimer, or an oligomer, a mixture of these, or the like.

Particularly, from the viewpoint of printing durability, the polymerizable compound preferably includes a polymerizable compound having functionalities of 3 or more, more preferably includes a polymerizable compound having functionalities of 7 or more, and even more preferably includes a polymerizable compound having functionalities of 10 or more. In addition, from the viewpoint of printing durability of the lithographic printing plate to be obtained, the polymerizable compound preferably includes an ethylenically unsaturated compound having functionalities of 3 or more (preferably having functionalities of 7 or more and more preferably having functionalities of 10 or more), and more preferably includes a (meth)acrylate compound having functionalities of 3 or more (preferably having functionalities of 7 or more and more preferably having functionalities of 10 or more).

From the viewpoints of on-press developability and contamination suppressiveness, the polymerizable compound preferably includes a polymerizable compound having functionalities of 2 or less, more preferably includes a difunctional polymerizable compound, and particularly preferably includes a difunctional (meth)acrylate compound.

From the viewpoints of printing durability, on-press developability, and contamination suppressiveness, the content of the polymerizable compound having functionalities of 2 or less (preferably a difunctional polymerizable compound) with respect to the total mass of polymerizable compounds in the image-recording layer is preferably 5% by mass to 100% by mass, more preferably 10% by mass to 100% by mass, and particularly preferably 15% by mass to 100% by mass.

-Oligomer-

As the polymerizable compound contained in the image-recording layer, it is preferable that a polymerizable compound which is an oligomer (hereinafter, also simply called "oligomer") is contained.

In the present disclosure, an oligomer represents a polymerizable compound which has a molecular weight (weight-average molecular weight in a case where the compound has molecular weight distribution) of 600 or more and 40,000 or less and contains at least one polymerizable group.

From the viewpoints of excellent chemical resistance and excellent printing durability, the molecular weight of the oligomer is preferably 1,000 or more and 25,000 or less.

In addition, from the viewpoint of improving printing durability, the number of polymerizable groups in one molecule of the oligomer is preferably 2 or more, more preferably 3 or more, even more preferably 6 or more, and particularly preferably 10 or more.

The upper limit value of the polymerizable groups in the oligomer is not particularly limited, but the number of polymerizable groups is preferably 20 or less.

From the viewpoints of printing durability and on-press developability, an oligomer having 7 or more polymerizable groups and a molecular weight of 1,000 or more and 40,000 or less is preferable, and an oligomer having 7 or more and 20 or less polymerizable groups and a molecular weight of 1,000 or more and 25,000 or less is more preferable.

The oligomer may contain a polymer component which is likely to be generated in the process of manufacturing the oligomer.

From the viewpoints of printing durability, visibility, and on-press developability, the oligomer preferably has at least one selected from the group consisting of a compound having a urethane bond, a compound having an ester bond, and a compound having an epoxy residue, and preferably has a compound having a urethane bond.

In the present disclosure, an epoxy residue refers to a structure formed of an epoxy group and for example, means a structure similar to a structure obtained by the reaction between an acid group (carboxylic acid group or the like) and an epoxy group.

As the compound having a urethane bond, those described in WO2020/262692A can be suitably used.

As the compound having a urethane bond, a compound may also be used which is prepared by obtaining polyurethane by a reaction between a polyisocyanate compound and a polyol compound and introducing a polymerizable group into the obtained polyurethane by a polymer reaction.

For example, the compound having a urethane bond may be obtained by reacting a polyol compound having an acid group with a polyisocyanate compound to obtain a polyurethane oligomer and reacting the obtained polyurethane oligomer with a compound having an epoxy group and a polymerizable group.

The number of polymerizable groups in the compound having an ester bond, which is an example of oligomer, is preferably 3 or more, and more preferably 6 or more.

As the compound having an epoxy residue, which is an example of oligomer, a compound containing a hydroxy group is preferable.

The number of polymerizable groups in the compound having an epoxy residue is preferably 2 to 6, and more preferably 2 or 3.

The compound having an epoxy residue can be obtained, for example, by reacting a compound having an epoxy group with an acrylic acid.

As the oligomer, commercially available products may also be used. Examples thereof include UA510H, UA-306H, UA-306I, and UA-306T (all manufactured by KYOEISHA CHEMICAL Co., Ltd.), UV-1700B, UV-6300B, and UV7620EA (all manufactured by The Nippon Synthetic Chemical Industry Co., Ltd.), U-15HA (manufactured by SHIN-NAKAMURA CHEMICAL Co., Ltd.), EBECRYL450, EBECRYL657, EBECRYL885, EBECRYL800, EBECRYL3416, and EBECRYL860 (all manufactured by DAICEL-ALLNEX LTD.), and the like. However, the oligomer is not limited to these.

From the viewpoints of improving chemical resistance, printing durability and, suppressiveness of the residues of on-press development, the content of the oligomer with respect to the total mass of polymerizable compounds in the image-recording layer is preferably 30% by mass to 100% by mass, more preferably 50% by mass to 100% by mass, and even more preferably 80% by mass to 100% by mass.

-Low-molecular-weight polymerizable compound-

The polymerizable compound may further include a polymerizable compound other than the oligomer described above.

From the viewpoint of chemical resistance, the polymerizable compound other than the oligomer is preferably a low-molecular-weight polymerizable compound. The low-molecular-weight polymerizable compound may take a chemical form such as a monomer, a dimer, a trimer, or a mixture of these.

From the viewpoint of chemical resistance, the low-molecular-weight polymerizable compound is preferably at least one polymerizable compound selected from the group consisting of a polymerizable compound having three or more ethylenically unsaturated groups and a polymerizable compound having an isocyanuric ring structure.

In the present disclosure, a low-molecular-weight polymerizable compound refers to a polymerizable compound having a molecular weight (weight-average molecular weight in a case where the compound has molecular weight distribution) of 50 or more and less than 800.

From the viewpoints of excellent chemical resistance, excellent printing durability, and excellent suppressiveness of the residues of on-press development, the molecular weight of the low-molecular-weight polymerizable compound is preferably 100 or more and less than 800, more preferably 300 or more and less than 800, and even more preferably 400 or more and less than 800.

In a case where the polymerizable compound includes a low-molecular-weight polymerizable compound as the polymerizable compound other than the oligomer, from the viewpoints of chemical resistance, printing durability, and suppressiveness of the residues of on-press development, the ratio (oligomer/low-molecular-weight polymerizable compound) of the oligomer to the low-molecular-weight polymerizable compound (total amount in a case where the polymerizable compound includes two or more low-molecular-weight polymerizable compounds) based on mass is preferably 10/1 to 1/10, more preferably 10/1 to 3/7, and even more preferably 10/1 to 7/3.

As the low-molecular-weight polymerizable compound, the polymerizable compounds described in paragraphs

"0082" to "0086" of WO2019/013268A can also be suitably used.

The details of how to use the polymerizable compound, such as the structure of the compound, whether the compound is used alone or used in combination with other compounds, and the additive amount of the compound, can be optionally set.

Particularly, from the viewpoint of printing durability, the image-recording layer preferably contains two or more polymerizable compounds.

The content of the polymerizable compound (total content of polymerizable compounds in a case where the image-recording layer contains two or more polymerizable compounds) with respect to the total mass of the image-recording layer is preferably 5% by mass to 75% by mass, more preferably 10% by mass to 70% by mass, and even more preferably 15% by mass to 60% by mass.

[Particles]

From the viewpoint of printing durability, the image-recording layer preferably contains particles.

The particles may be organic particles or inorganic particles. From the viewpoint of printing durability, the image-recording layer preferably contains organic particles, and more preferably contains polymer particles.

As inorganic particles, known inorganic particles can be used, and metal oxide particles such as silica particles and titania particles can be suitably used.

The polymer particles are preferably selected from the group consisting of thermoplastic resin particles, thermal reactive resin particles, polymer particles having a polymerizable group, microcapsules encapsulating a hydrophobic compound, and a microgel (crosslinked polymer particles). Among these, polymer particles having a polymerizable group or a microgel are preferable. In a particularly preferred embodiment, the polymer particles have at least one ethylenically unsaturated group. The presence of such polymer particles brings about effects of improving the printing durability of an exposed portion and improving the on-press developability of a non-exposed portion.

From the viewpoints of printing durability and on-press developability, the polymer particles are preferably thermoplastic resin particles.

The thermoplastic resin particles are preferably the thermoplastic polymer particles described in Research Disclosure No. 33303 published in January 1992, JP1997-123387A (JP-H09-123387A), JP1997-131850A (JP-H09-131850A), JP1997-171249A (JP-H09-171249A), JP1997-171250A (JP-H09-171250A), EP931647B, and the like.

Specific examples of polymers constituting the thermoplastic resin particles include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylate or methacrylate having a polyalkylene structure, and the like and mixtures of these. Preferred examples thereof can include polystyrene, copolymers having styrene and acrylonitrile, or polymethyl methacrylate. The average particle diameter of the thermoplastic resin particle is preferably 0.01 μm to 3.0 μm.

Examples of the thermal reactive resin particles include polymer particles having a thermal reactive group. The thermal reactive polymer particles form a hydrophobilized region through crosslinking by a thermal reaction and the accompanying change in functional groups.

The thermal reactive group in the polymer particles having a thermal reactive group may be a functional group that causes any reaction as long as chemical bonds are formed, and is preferably a polymerizable group. Preferred examples thereof include an ethylenically unsaturated group that causes a radical polymerization reaction (for example, an acryloyl group, a methacryloyl group, a vinyl group, an allyl group, and the like), a cationically polymerizable group (for example, a vinyl group, a vinyloxy group, an epoxy group, an oxetanyl group, and the like), an isocyanato group or a blocked isocyanato group that causes an addition reaction, an epoxy group, a vinyloxy group, an active hydrogen atom-containing functional group that is a reaction partner thereof (for example, an amino group, a hydroxy group, a carboxy group, and the like), a carboxy group that causes a condensation reaction, a hydroxy group or an amino group that is a reaction partner of the carboxy group, an acid anhydride that causes a ring-opening addition reaction, an amino group or a hydroxy group which is a reaction partner of the acid anhydride, and the like.

Examples of the microcapsules include microcapsules encapsulating at least some of the constituent components of the image-recording layer as described in JP2001-277740A and JP2001-277742A. The constituent components of the image-recording layer can also be contained in the exterior of the microcapsules. In a preferred aspect, the image-recording layer containing microcapsules is constituted such that hydrophobic constituent components are encapsulated in the microcapsules and hydrophilic constituent components are contained in the exterior of the microcapsules.

The microgel (crosslinked polymer particles) can contain some of the constituent components of the image-recording layer, in at least one of the surface or the interior of the microgel. From the viewpoints of sensitivity of the lithographic printing plate precursor to be obtained and printing durability of the lithographic printing plate to be obtained, a reactive microgel having a radically polymerizable group on the surface thereof is particularly preferable.

In order to encapsulate the constituent components of the image-recording layer in microcapsules or microgel,

known methods can be used.

From the viewpoints of printing durability, antifouling property, and storage stability of the lithographic printing plate to be obtained, the polymer particles are preferably polymer particles which are obtained by a reaction of a polyvalent isocyanate compound that is an adduct of a polyhydric phenol compound having two or more hydroxy groups in a molecule and isophorone diisocyanate with a compound having active hydrogen.

The polyhydric phenol compound is preferably a compound having a plurality of benzene rings having a phenolic hydroxy group.

The compound having active hydrogen is preferably a polyol compound or a polyamine compound, more preferably a polyol compound, and even more preferably at least one compound selected from the group consisting of propylene glycol, glycerin, and trimethylolpropane.

Preferred examples of the resin particles obtained by the reaction of a polyvalent isocyanate compound that is an adduct of a polyhydric phenol compound having two or more hydroxy groups in a molecule and isophorone diisocyanate, with a compound having active hydrogen include the polymer particles described in paragraphs "0032" to "0095" of JP2012-206495A.

Furthermore, from the viewpoint of printing durability and solvent resistance of the lithographic printing plate to be obtained, the polymer particles preferably have a hydrophobic main chain and include both i) constitutional unit having a pendant cyano group directly bonded to the hydrophobic main chain and ii) constitutional unit having a pendant group including a hydrophilic polyalkylene oxide segment.

Preferred examples of the hydrophobic main chain include an acrylic resin chain.

Preferred examples of the pendant cyano group include $-[CH_2CH(C\equiv N)]-$ or $-[CH_2C(CH_3)(C\equiv N)]-$.

In addition, the constitutional unit having the pendant cyano group can be easily derived from an ethylenically unsaturated monomer, for example, acrylonitrile or methacrylonitrile, or a combination of these.

Furthermore, as an alkylene oxide in the hydrophilic polyalkylene oxide segment, ethylene oxide or a propylene oxide is preferable, and ethylene oxide is more preferable.

The number of repeating alkylene oxide structures in the hydrophilic polyalkylene oxide segment is preferably 10 to 100, more preferably 25 to 75, and even more preferably 40 to 50.

As the resin particles having a hydrophobic main chain and including both i) constitutional unit having the pendant cyano group directly bonded to the hydrophobic main chain and ii) constitutional unit having a pendant group including the hydrophilic polyalkylene oxide segment, for example, the particles described in paragraphs "0039" to "0068" of JP2008-503365A are preferable.

From the viewpoints of printing durability and on-press developability, the polymer particles preferably have a hydrophilic group.

The hydrophilic group is not particularly limited as long as it has a hydrophilic structure, and examples thereof include an acid group such as a carboxy group, a hydroxy group, an amino group, a cyano group, a polyalkylene oxide structure, and the like.

Among these, from the viewpoints of on-press developability and printing durability, a polyalkylene oxide structure is preferable, and a polyethylene oxide structure, a polypropylene oxide structure, or a polyethylene/propylene oxide structure is more preferable.

In addition, from the viewpoints of on-press developability and suppressiveness of the residues of development during on-press development, the polyalkylene oxide structure preferably has a polypropylene oxide structure, and more preferably has a polyethylene oxide structure and a polypropylene oxide structure.

From the viewpoints of printing durability, receptivity, and on-press developability, the hydrophilic group preferably has a constitutional unit having a cyano group, or a group represented by Formula Z, more preferably has a constitutional unit represented by Formula (AN) or a group represented by Formula Z, and particularly preferably has a group represented by Formula Z.

$$*\text{-Q-W-Y} \qquad \text{Formula Z}$$

In Formula Z, Q represents a divalent linking group, W represents a divalent group having a hydrophilic structure or a divalent group having a hydrophobic structure, and Y represents a monovalent group having a hydrophilic structure or a monovalent group having a hydrophobic structure, either W or Y has a hydrophilic structure, and * represents a bonding site with another structure.

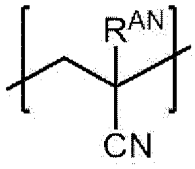

( AN )

In Formula (AN), $R^{AN}$ represents a hydrogen atom or a methyl group.

From the viewpoint of printing durability, the polymer contained in the polymer particles preferably has a constitutional unit formed of a compound having a cyano group.

Generally, it is preferable that a cyano group is introduced as a constitutional unit having a cyano group into a resin by using a compound (monomer) having a cyano group. Examples of the compound having a cyano group include acrylonitrile compounds and suitable examples thereof include (meth)acrylonitrile.

The constitutional unit having a cyano group is preferably a constitutional unit formed of an acrylonitrile compound, and more preferably a constitutional unit formed of (meth)acrylonitrile, that is, a constitutional unit represented by Formula (AN).

In a case where the polymer includes a polymer having a constitutional unit having a cyano group, from the viewpoint of printing durability, the content of the constitutional unit having a cyano group which is preferably a constitutional unit represented by Formula (AN) in the polymer having the constitutional unit having a cyano group with respect to the total mass of the polymer having the constitutional unit having a cyano group is preferably 5% by mass to 90% by mass, more preferably 20% by mass to 80% by mass, and particularly preferably 30% by mass to 60% by mass.

In addition, from the viewpoints of printing durability, receptivity, and on-press developability, the polymer particles preferably include polymer particles having a group represented by Formula Z.

Q in Formula Z is preferably a divalent linking group having 1 to 20 carbon atoms, and more preferably a divalent linking group having 1 to 10 carbon atoms.

In addition, Q in Formula Z is preferably an alkylene group, an arylene group, an ester bond, an amide bond, or a group formed by combining two or more of these, and more preferably a phenylene group, an ester bond, or an amide bond.

The divalent group having a hydrophilic structure represented by W in Formula Z is preferably a polyalkyleneoxy group or a group in which $-CH_2CH_2NR^W-$ is bonded to one terminal of a polyalkyleneoxy group. $R^W$ represents a hydrogen atom or an alkyl group.

The divalent group having a hydrophobic structure represented by W in Formula Z is preferably $-R^{WA}-$, $-O-R^{WA}-O-$, $-R^WN-R^{WA}-NR^W-$, $-OC(=O)-R^{WA}-O-$, or $-OC(=O)-R^{WA}-O-$. $R^{WA}$'s each independently represent a linear, branched, or cyclic alkylene group having a carbon number of 6 to 120, a haloalkylene group having a carbon number of 6 to 120, an arylene group having a carbon number of 6 to 120, an alkarylene group having a carbon number of 6 to 120 (divalent group formed by removing one hydrogen atom from an alkylaryl group), or an aralkylene group having a carbon number of 6 to 120.

The monovalent group having a hydrophilic structure represented by Y in Formula Z is preferably -OH, -C(=O)OH, a polyalkyleneoxy group having a hydrogen atom or an alkyl group on a terminal, or a group in which $-CH_2CH_2NR^W-$ is bonded to one terminal of a polyalkyleneoxy group having a hydrogen atom or an alkyl group on the other terminal.

The monovalent group having a hydrophobic structure represented by Y in Formula Z is preferably a linear, branched, or cyclic alkyl group having 6 to 120 carbon atoms, a haloalkyl group having 6 to 120 carbon atoms, an aryl group having 6 to 120 carbon atoms, an alkaryl group (alkylaryl group) having 7 to 120 carbon atoms, an aralkyl group having 7 to 120 carbon atoms, $-OR^{WB}$, $-C(=O)OR^{WB}$, or $-OC(=O)R^{WB}$. $R^{WB}$ represents an alkyl group having 6 to 20 carbon atoms.

From the viewpoints of printing durability, receptivity, and on-press developability, in the polymer particles having a group represented by formula Z, W is preferably a divalent group having a hydrophilic structure, and it is more preferable that Q is a phenylene group, an ester bond, or an amide bond, W is a polyalkyleneoxy group, and Y is a polyalkyleneoxy group having a hydrogen atom or an alkyl group on a terminal.

In addition, from the viewpoints of printing durability and on-press developability, the polymer particles preferably include polymer particles having a polymerizable group, and more preferably include polymer particles having a polymerizable group on the particle surface.

Furthermore, from the viewpoint of printing durability, the polymer particles preferably include polymer particles having a hydrophilic group and a polymerizable group.

The polymerizable group may be a cationically polymerizable group or a radically polymerizable group and, from the viewpoint of reactivity, is preferably a radically polymerizable group.

The polymerizable group is not particularly limited as long as it is a polymerizable group, but from the viewpoint of

reactivity, is preferably an ethylenically unsaturated group, more preferably a vinylphenyl group (styryl group), a (meth) acryloxy group, or a (meth)acrylamide group, and particularly preferably a (meth)acryloxy group.

In addition, the polymer in the polymer particles having a polymerizable group preferably has a constitutional unit having a polymerizable group.

The polymerizable group may be introduced into the surface of the polymer particles by a polymer reaction.

In addition, from the viewpoints of printing durability and on-press developability, the image-recording layer preferably contains, as the polymer particles, addition polymerization-type resin particles having a dispersible group which more preferably includes a group represented by Formula Z.

From the viewpoints of printing durability, receptivity, on-press developability, and suppressiveness of the residues of development during on-press development, the polymer particles preferably contain a resin having a urea bond.

Suitable examples of the resin having a urea bond include those described in WO2020/262692A.

From the viewpoints of printing durability and on-press developability, the image-recording layer preferably contains thermoplastic resin particles.

The thermoplastic resin contained in the thermoplastic resin particles is not particularly limited, and examples thereof include polyethylene, polystyrene, polyvinyl chloride, polyvinylidene chloride, polymethyl (meth)acrylate, polyethyl (meth)acrylate, polybutyl (meth)acrylate, polyacrylonitrile, polyvinyl acetate, copolymers of these, and the like. The thermoplastic resin may be in the state of latex.

The thermoplastic resin according to the present disclosure is preferably a resin which melts or softens by heat generated in an exposure step that will be described later and thus forms a part or the entirety of a hydrophobic film forming the image-recording layer.

From the viewpoints of ink receptivity and printing durability, the thermoplastic resin preferably contains a resin having a constitutional unit formed of an aromatic vinyl compound and a constitutional unit having a cyano group.

Suitable examples of the resin having a constitutional unit formed of an aromatic vinyl compound and a constitutional unit having a cyano group include those described in WO2020/262692A.

From the viewpoints of printing durability and on-press developability, the thermoplastic resin contained in the thermoplastic resin particles preferably has a hydrophilic group.

The hydrophilic group is not particularly limited as long as it has a hydrophilic structure, and examples thereof include an acid group such as a carboxy group, a hydroxy group, an amino group, a cyano group, a polyalkylene oxide structure, and the like.

From the viewpoints of printing durability and on-press developability, the hydrophilic group is preferably a group having a polyalkylene oxide structure, a group having a polyester structure, or a sulfonic acid group, more preferably a group having a polyalkylene oxide structure or a sulfonic acid group, and even more preferably a group having a polyalkylene oxide structure.

From the viewpoint of on-press developability, the polyalkylene oxide structure is preferably a polyethylene oxide structure, a polypropylene oxide structure, or a poly(ethylene oxide/propylene oxide) structure.

In addition, from the viewpoint of on-press developability, among the hydrophilic groups, as a polyalkylene oxide structure, groups having a polypropylene oxide structure are preferable, and groups having a polyethylene oxide structure and a polypropylene oxide structure are more preferable.

From the viewpoint of on-press developability, the number of alkylene oxide structures in the polyalkylene oxide structure is preferably 2 or more, more preferably 5 or more, even more preferably 5 to 200, and particularly preferably 8 to 150.

In addition, from the viewpoint of on-press developability, the hydrophilic group is preferably a group represented by Formula Z.

From the viewpoints of printing durability and ink receptivity, the glass transition temperature (Tg) of the thermoplastic resin is preferably 60°C to 150°C, more preferably 80°C to 140°C, and even more preferably 90°C to 130°C.

In a case where the thermoplastic resin particles contain two or more types of thermoplastic resins, the value obtained by the FOX equation that will be described later is referred to as the glass transition temperature of the thermoplastic resin.

In the present disclosure, the glass transition temperature of a resin can be measured by differential scanning calorimetry (DSC).

Specifically, the glass transition temperature is measured according to the method described in JIS K 7121 (1987) or JIS K 6240 (2011). As the glass transition temperature in the present specification, an extrapolated glass transition initiation temperature (hereinafter, may be referred to as Tig) is used.

The method of measuring the glass transition temperature will be described in more detail.

In a case of determining the glass transition temperature, the device is kept at a temperature approximately 50°C lower than the expected Tg of the resin until the device stabilizes. Then, the resin is heated at a heating rate of 20 °C/min to a temperature approximately 30°C higher than the temperature at which the glass transition ends, and a differential

thermal analysis (DTA) curve or a DSC curve is created.

The extrapolated glass transition initiation temperature (Tig), that is, the glass transition temperature Tg in the present specification is determined as a temperature at an intersection point between a straight line that is obtained by extending the baseline of a low temperature side in the DTA curve or the DSC curve to a high temperature side and a tangent line that is drawn at a point where the slope of the curve of a portion in which the glass transition changes stepwisely is maximum.

In a case where the thermoplastic resin particles contain two or more types of thermoplastic resins, Tg of the thermoplastic resins contained in the thermoplastic resin particles is determined as follows.

In a case where Tg1 (K) represents Tg of a first thermoplastic resin, W1 represents the mass ratio of the first thermoplastic resin to the total mass of thermoplastic resin components in the thermoplastic resin particles, Tg2 (K) represents second Tg, and W2 represents the mass ratio of the second resin to the total mass of thermoplastic resin components in the thermoplastic resin particles, Tg0 (K) of the thermoplastic resin particles can be estimated according to the following FOX equation.

FOX equation:

$$1/Tg0 = (W1/Tg1) + (W2/Tg2)$$

In addition, in a case where the thermoplastic resin particles contain three types of resins or in a case where three types of thermoplastic resin particles each containing different types of thermoplastic resins are contained in a pretreatment liquid, similarly to the case described above, in a case where Tgn (K) represents Tg of nth resin and Wn represents the mass ratio of the nth resin to the total mass of resin components in the thermoplastic resin particles, Tg of the thermoplastic resin particles can be estimated according to the following equation.

FOX equation:

$$1/Tg0 = (W1/Tg1) + (W2/Tg2) + (W3/Tg3) \cdots + (Wn/Tgn)$$

As the differential scanning calorimeter (DSC), for example, EXSTAR 6220 manufactured by SII NanoTechnology Inc. can be used.

From the viewpoint of printing durability, the arithmetic mean particle diameter of the thermoplastic resin particles is preferably 1 nm or more and 200 nm or less, more preferably 3 nm or more and less than 80 nm, and even more preferably 10 nm or more and 49 nm or less.

Unless otherwise specified, the arithmetic mean particle diameter of the thermoplastic resin particles in the present disclosure refers to a value measured by a dynamic light scattering method (DLS). The measurement of the arithmetic mean particle diameter of the thermoplastic resin particles by DLS is carried out using Brookhaven BI-90 (manufactured by Brookhaven Instruments) according to the manual of the instrument.

The weight-average molecular weight of the thermoplastic resin contained in the thermoplastic resin particles is preferably 3,000 to 300,000, and more preferably 5,000 to 100,000.

The manufacturing method of the thermoplastic resin contained in the thermoplastic resin particles is not particularly limited, and the thermoplastic resin can be manufactured by known methods.

For example, the thermoplastic resin is obtained by polymerizing a styrene compound, an acrylonitrile compound, and as necessary, at least one optional compound selected from the group consisting of an N-vinyl heterocyclic compound, a compound used for forming a constitutional unit having an ethylenically unsaturated group, a compound used for forming a constitutional unit having an acidic group, a compound used for forming a constitutional unit having a hydrophobic group, and a compound used for forming the other constitutional units, by known methods.

Specifically, suitable examples of the thermoplastic resin contained in the thermoplastic resin particles include those described in WO2020/262692A.

The average particle diameter of the particles is preferably 0.01 μm to 3.0 μm, more preferably 0.03 μm to 2.0 μm, and still more preferably 0.10 μm to 1.0 μm. In a case where the average particle diameter is in this range, excellent resolution and excellent temporal stability are obtained.

The average primary particle diameter of the particles in the present disclosure is obtained by measuring with a light scattering method or by imaging an electron micrograph of the particles, measuring the particle diameter of a total of 5,000 particles in the photograph, and calculating the average value thereof. For non-spherical particles, the value of particle diameter of spherical particles having the same area as the area of the particles on the photograph is adopted as the particle diameter.

Unless otherwise specified, the average particle diameter in the present disclosure means a volume average particle diameter.

The image-recording layer may contain only one type of particles, particularly, one type of polymer particles or

two or more types of polymer particles.

From the viewpoints of on-press developability and printing durability, the content of particles, particularly, the content of polymer particles in the image-recording layer with respect to the total mass of the image-recording layer is preferably 5% by mass to 90% by mass, more preferably 10% by mass to 90% by mass, even more preferably 20% by mass to 90% by mass, and particularly preferably 50% by mass to 90% by mass.

In addition, from the viewpoints of on-press developability and printing durability, the content of the polymer particles in the image-recording layer with respect to the total mass of components having a molecular weight of 3,000 or more in the image-recording layer is preferably 20% by mass to 100% by mass, more preferably 35% by mass to 100% by mass, even more preferably 50% by mass to 100% by mass, and particularly preferably 80% by mass to 100% by mass.

[Binder polymer]

The image-recording layer may contain a binder polymer.

The above-described polymer particles do not correspond to the binder polymer. That is, the binder polymer is a polymerized substance that is not in the form of particles.

The binder polymer is preferably a (meth)acrylic resin, a polyvinyl acetal resin, or a polyurethane resin.

Among these, as the binder polymer, known binder polymers that can be used in an image-recording layer in lithographic printing plate precursors can be suitably used. As an example, a binder polymer that is used for an on-press development type lithographic printing plate precursor (hereinafter, also called binder polymer for on-press development) will be specifically described.

As the binder polymer for on-press development, a binder polymer having an alkylene oxide chain is preferable. The binder polymer having an alkylene oxide chain may have a poly(alkylene oxide) moiety in a main chain or side chain. In addition, the binder polymer may be a graft polymer having poly(alkylene oxide) in a side chain or a block copolymer of a block composed of a poly(alkylene oxide)-containing repeating unit and a block composed of an (alkylene oxide)-free repeating unit.

In a case where the binder polymer has a poly(alkylene oxide) moiety in the main chain, a polyurethane resin is preferable. Examples of polymers as the main chain in a case where the binder polymer has a poly(alkylene oxide) moiety in the side chain include a (meth)acrylic resin, a polyvinyl acetal resin, a polyurethane resin, a polyurea resin, a polyimide resin, a polyamide resin, an epoxy resin, a polystyrene resin, a novolac-type phenol resin, a polyester resin, synthetic rubber, and natural rubber, and a (meth)acrylic resin is particularly preferable.

In addition, other preferred examples of the binder polymer include a polymer compound which has a polyfunctional thiol having functionalities of 6 or more and 10 or less as a nucleus and a polymer chain that is bonded to the nucleus by a sulfide bond and has a polymerizable group (hereinafter, this compound will be also called star-shaped polymer compound).

From the viewpoint of curability, preferred examples of the star-shaped polymer compound include a star-shaped polymer compound having a polymerizable group such as an ethylenically unsaturated group on a main chain or a side chain, and more preferably on a side chain.

Examples of the star-shaped polymer compound include those described in JP2012-148555A or WO2020/262692A.

The molecular weight of the binder polymer that is a polystyrene-equivalent weight-average molecular weight (Mw) determined by GPC is preferably 2,000 or more, more preferably 5,000 or more, and even more preferably 10,000 to 300,000.

As necessary, a hydrophilic polymer such as polyacrylic acid or polyvinyl alcohol described in JP2008-195018A can be used in combination. In addition, a lipophilic polymer and a hydrophilic polymer can be used in combination.

From the viewpoints of printing durability and on-press developability, the image-recording layer preferably contains a polymer having a constitutional unit formed of an aromatic vinyl compound, and more preferably contains a polymer having a constitutional unit formed of an aromatic vinyl compound and an infrared absorber which decomposes by exposure to infrared rays.

In addition, for example, from the viewpoint of inhibiting on-press developability from deteriorating with the passage of time, the glass transition temperature (Tg) of the binder polymer used in the present disclosure is preferably 50°C or higher, more preferably 70°C or higher, even more preferably 80°C or higher, and particularly preferably 90°C or higher.

Furthermore, from the viewpoint of ease of permeation of water into the image-recording layer, the upper limit of the glass transition temperature of the binder polymer is preferably 200°C, and more preferably 120°C or lower.

From the viewpoint of further inhibiting on-press developability from deteriorating with the passage of time, the binder polymer having the above-described glass transition temperature is preferably polyvinyl acetal.

Polyvinyl acetal is a resin obtained by acetalizing a hydroxy group of polyvinyl alcohol with an aldehyde.

Particularly, polyvinyl butyral is preferable which is obtained by acetalizing (that is, butyralizing) a hydroxy group

of polyvinyl alcohol with butyraldehyde.

From the viewpoint of improving printing durability, the polyvinyl acetal preferably has an ethylenically unsaturated group.

Suitable examples of the polyvinyl acetal include those described in WO2020/262692A.

The image-recording layer in the present disclosure preferably contains a resin having a fluorine atom, and more preferably contains a fluoroaliphatic group-containing copolymer.

In a case where the resin having a fluorine atom, particularly, the fluoroaliphatic group-containing copolymer is used, it is possible to inhibit surface abnormalities resulting from foaming during the formation of the image-recording layer and to improve the condition of the coated surface, and further to improve the ink receptivity of the formed image-recording layer.

In addition, the image-recording layer containing the fluoroaliphatic group-containing copolymer has high gradation and is highly sensitive, for example, to laser light. Therefore, the obtained lithographic printing plate exhibits excellent fogging property by scattered light, reflected light, and the like and has excellent printing durability.

As the fluoroaliphatic group-containing copolymer, those described in WO2020/262692A can be suitably used.

In the image-recording layer used in the present disclosure, one binder polymer may be used alone, or two or more binder polymers may be used in combination.

The content of the binder polymer to be contained in the image-recording layer can be optionally set, and the content of the binder polymer with respect to the total mass of the image-recording layer is preferably 1% by mass to 90% by mass and more preferably 5% by mass to 80% by mass.

[Chain transfer agent]

The image-recording layer used in the present disclosure may contain a chain transfer agent. The chain transfer agent contributes to the improvement of printing durability of the lithographic printing plate.

The chain transfer agent is preferably a thiol compound, more preferably a thiol compound having 7 or more carbon atoms from the viewpoint of boiling point (low volatility), and even more preferably a compound having a mercapto group on an aromatic ring (aromatic thiol compound). The thiol compound is preferably a monofunctional thiol compound.

Specifically, suitable examples of the chain transfer agent include those described in WO2020/262692A.

Only one type of chain transfer agent may be added to the image-recording layer, or two or more types thereof may be used in combination.

The content of the chain transfer agent with respect to the total mass of the image-recording layer is preferably 0.01% by mass to 50% by mass, more preferably 0.05% by mass to 40% by mass, and even more preferably 0.1% by mass to 30% by mass.

[Oil sensitizing agent]

In order to improve ink receptivity, the image-recording layer preferably further contains an oil sensitizing agent.

Examples of the oil sensitizing agent include an onium compound, a nitrogen-containing low-molecular-weight compound, an ammonium compound such as an ammonium group-containing polymer, and the like.

Particularly, in a case where an inorganic lamellar compound is incorporated into an outermost layer, these compounds function as a surface coating agent for the inorganic lamellar compound and can inhibit the receptivity deterioration caused in the middle of printing by the inorganic lamellar compound.

In addition, from the viewpoint of receptivity, the oil sensitizing agent is preferably an onium compound.

Examples of the onium compound include a phosphonium compound, an ammonium compound, a sulfonium compound, and the like. From the viewpoint described above, the onium compound is preferably at least one compound selected from the group consisting of a phosphonium compound and an ammonium compound.

Preferred examples of the ammonium compound can include a nitrogen-containing low-molecular-weight compound, an ammonium group-containing polymer, and the like.

Specifically, suitable examples of the oil sensitizing agent include those described in WO2020/262692A.

The content of the oil sensitizing agent with respect to the total mass of the image-recording layer is preferably 1% by mass to 40.0% by mass, more preferably 2% by mass to 25.0% by mass, and even more preferably 3% by mass to 20.0% by mass.

The image-recording layer may contain only one type of oil sensitizing agent, or two or more types of oil sensitizing agents may be used in combination.

One of the preferred aspects of the image-recording layer used in the present disclosure is an aspect in which the image-recording layer contains two or more types of compounds as an oil sensitizing agent.

Specifically, from the viewpoint of satisfying both the on-press developability and receptivity, the image-recording layer used in the present disclosure preferably uses all the phosphonium compound, the nitrogen-containing low-molecular-weight compound, and the ammonium group-containing polymer as an oil sensitizing agent, and more preferably uses all the phosphonium compound, the quaternary ammonium salts, and the ammonium group-containing polymer as an oil sensitizing agent.

[Development accelerator]

The image-recording layer used in the present disclosure preferably further contains a development accelerator.
The value of polarity element as an SP value of the development accelerator is preferably 6.0 to 26.0, more preferably 6.2 to 24.0, even more preferably 6.3 to 23.5, and particularly preferably 6.4 to 22.0.
In the present disclosure, as the value of polarity element as an SP value (solubility parameter, unit: $(cal/cm^3)^{1/2}$), the value of polarity element δp in the Hansen solubility parameters is used. The Hansen solubility parameters are obtained by dividing the solubility parameters introduced by Hildebrand into three components, a dispersion element δd, a polarity element δp, and a hydrogen bond element δh, and expressing the parameters in a three-dimensional space. In the present disclosure, the polarity element δp is used.
δp $[cal/cm^3]$ is a dipole-dipole force element in the Hansen solubility parameters, V $[cal/cm^3]$ is a molar volume, and μ [D] is a dipole moment. As δp, the following equation simplified by Hansen and Beerbower is generally used.

$$\delta_p = \frac{37.4\mu}{V^{1/2}}$$

The development accelerator is preferably a hydrophilic polymer compound or a hydrophilic low-molecular-weight compound.
In the present disclosure, "hydrophilic" means that the value of polarity element as an SP value is 6.0 to 26.0, the hydrophilic polymer compound refers to a compound having a molecular weight (weight-average molecular weight in a case where the compound has molecular weight distribution) of 3,000 or more, and the hydrophilic low-molecular-weight compound refers to a compound having a molecular weight (weight-average molecular weight in a case where the compound has molecular weight distribution) of less than 3,000.
Examples of the hydrophilic polymer compound include a cellulose compound and the like. Among these, a cellulose compound is preferable.
Examples of the cellulose compound include cellulose or a compound obtained by modifying at least a part of cellulose (modified cellulose compound). Among these, a modified cellulose compound is preferable.
Preferred examples of the modified cellulose compound include a compound which is obtained by substituting at least some of hydroxy groups of cellulose with at least one type of group selected from the group consisting of an alkyl group and a hydroxyalkyl group.
The degree of substitution of the compound, which is obtained by substituting at least some of hydroxy groups of cellulose with at least one type of group selected from the group consisting of an alkyl group and a hydroxyalkyl group, is preferably 0.1 to 6.0, and more preferably 1 to 4.
As the modified cellulose compound, an alkyl cellulose compound or a hydroxyalkyl cellulose compound is preferable, and a hydroxyalkyl cellulose compound is more preferable.
Preferred examples of the alkyl cellulose compound include methyl cellulose.
Preferred examples of the hydroxyalkyl cellulose compound include hydroxypropyl cellulose.
The molecular weight of the hydrophilic polymer compound (weight-average molecular weight in a case where the compound has molecular weight distribution) is preferably 3,000 to 5,000,000, and more preferably 5,000 to 200,000.
Examples of the hydrophilic low-molecular-weight compound include a glycol compound, a polyol compound, an organic amine compound, an organic sulfonic acid compound, an organic sulfamine compound, an organic sulfuric acid compound, an organic phosphonic acid compound, an organic carboxylic acid compound, a betaine compound, and the like. Among these, a polyol compound, an organic sulfonic acid compound, or a betaine compound is preferable.
Examples of the glycol compound include glycols such as ethylene glycol, diethylene glycol, triethylene glycol, propylene glycol, dipropylene glycol, and tripropylene glycol, and ether or ester derivatives of these compounds.
Examples of the polyol compound include glycerin, pentaerythritol, tris(2-hydroxyethyl) isocyanurate, and the like.
Examples of the organic amine compound include triethanolamine, diethanolamine, monoethanolamine, salts of these, and the like.
Examples of the organic sulfonic acid compound include alkyl sulfonic acid, toluene sulfonic acid, benzene sulfonic acid, salts of these, and the like. Among these, for example, alkyl sulfonic acid having an alkyl group having 1 to 10 carbon atoms is preferable.

Examples of the organic sulfamine compound include alkylsulfamic acid, salts thereof, and the like.
Examples of the organic sulfuric acid compound include alkyl sulfate, alkyl ether sulfuric acid, salts of these, and the like.
Examples of the organic phosphonic acid compound include phenylphosphonic acid, salts thereof, and the like.
Examples of the organic carboxylic acid compound include tartaric acid, oxalic acid, citric acid, malic acid, lactic acid, gluconic acid, salts of these, and the like.
Examples of the betaine compound include a phosphobetaine compound, a sulfobetaine compound, a carboxybetaine compound, and the like. Among these, for example, trimethylglycine is preferable.
The molecular weight of the hydrophilic low-molecular-weight compound (weight-average molecular weight in a case where the compound has molecular weight distribution) is preferably 100 or more and less than 3,000, and more preferably 300 to 2,500.
The development accelerator is preferably a compound having a cyclic structure.
The cyclic structure is not particularly limited. Examples thereof include a glucose ring in which at least some of hydroxy groups may be substituted, an isocyanuric ring, an aromatic ring which may have a heteroatom, an aliphatic ring which may have a heteroatom, and the like. Among these, for example, a glucose ring or an isocyanuric ring is preferable.
Examples of the compound having a glucose ring include the aforementioned cellulose compound.
Examples of the compound having an isocyanuric ring include the aforementioned tris(2-hydroxyethyl) isocyanurate and the like.
Examples of the compound having an aromatic ring include the toluene sulfonic acid and benzene sulfonic acid described above, and the like.
Examples of the compound having an aliphatic ring include a compound which is the aforementioned alkyl sulfate and has an alkyl group having a ring structure, and the like.
The compound having a cyclic structure preferably has a hydroxy group.
Preferred examples of the compound having a hydroxy group and a cyclic structure include the aforementioned cellulose compound and the aforementioned tris(2-hydroxyethyl) isocyanurate.
In addition, an onium compound is preferable as the development accelerator.
Examples of the onium compound include an ammonium compound and a sulfonium compound. Among these, an ammonium compound is preferable.
Examples of the development accelerator which is an onium compound include trimethylglycine.
In addition, the onium compound in the electron-accepting polymerization initiator is a compound in which the value of polarity element of the SP value is not in the range of 6.0 to 26.0 and is not included in the development accelerator.
The image-recording layer may contain only one type of development accelerator, or two or more types of development accelerators may be used in combination.
One of the preferred aspects of the image-recording layer used in the present disclosure is an aspect in which the image-recording layer contains two or more types of compounds as a development accelerator.
Specifically, from the viewpoint of on-press developability and receptivity, the image-recording layer used in the present disclosure preferably contains, as a development accelerator, the polyol compound and the betaine compound described above, the betaine compound and the organic sulfonic acid compound described above, or the polyol compound and the organic sulfonic acid compound described above.
The content of the development accelerator with respect to the total mass of the image-recording layer is preferably 0.1% by mass or more and 20% by mass or less, more preferably 0.5% by mass or more and 15% by mass or less, and even more preferably 1% by mass or more and 10% by mass or less.

[Other components]

As other components, a surfactant, a polymerization inhibitor, a higher fatty acid derivative, a plasticizer, an inorganic lamellar compound, and the like can be incorporated into the image-recording layer. Specifically, the description in paragraphs "0114" to "0159" of JP2008-284817A can be referred to.
As the polymerization inhibitor, for example, a known polymerization inhibitor such as phenothiazine can be used.

[Formation of image-recording layer]

The image-recording layer in the lithographic printing plate precursor according to the present disclosure can be formed, for example, by preparing a coating liquid by dispersing or dissolving the necessary components described above in a known solvent, coating a support with the coating liquid by a known method such as bar coating, and drying the coating liquid, as described in paragraphs "0142" and "0143" of JP2008-195018A.
As the solvent, known solvents can be used. Specific examples thereof include water, acetone, methyl ethyl

ketone (2-butanone), cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 1-methoxy-2-propanol, 3-methoxy-1-propanol, methoxy methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, $\gamma$-butyrolactone, methyl lactate, ethyl lactate, and the like. Only one type of solvent may be used, or two or more types of solvents may be used in combination. The concentration of solid contents in the coating liquid is preferably 1% by mass to 50% by mass.

The coating amount (solid content) of the image-recording layer after coating and drying varies with uses, but from the viewpoint of obtaining excellent sensitivity and excellent film characteristics of the image-recording layer, is preferably 0.3 $g/m^2$ to 3.0 $g/m^2$.

In addition, the layer thickness of the image-recording layer is preferably 0.1 $\mu$m to 3.0 $\mu$m and more preferably 0.3 $\mu$m to 2.0 $\mu$m.

In the present disclosure, the layer thickness of each layer in the lithographic printing plate precursor is checked by preparing a slice by cutting the lithographic printing plate precursor in a direction perpendicular to the surface of the precursor and observing the cross section of the slice with a scanning electron microscope (SEM).

<Support>

The lithographic printing plate precursor according to the present disclosure has a support.

The support to be used can be appropriately selected from known supports for a lithographic printing plate precursor.

The support is preferably a support having a hydrophilic surface (hereinafter, also called "hydrophilic support").

As the support in the present disclosure, an aluminum plate is preferable which has been roughened using a known method and has undergone an anodization treatment. That is, the support in the present disclosure preferably has an aluminum plate and an anodic oxide coating film of aluminum, disposed on the aluminum plate.

In addition, it is preferable that the support has an aluminum plate and an anodic oxide film of aluminum, disposed on the aluminum plate, the anodic oxide film is positioned closer to the image-recording layer side than the aluminum plate and has micropores extending in a depth direction from the surface of the anodic oxide film on the image-recording layer side, and the average diameter of the micropores within the surface of the anodic oxide film is more than 10 nm and 100 nm or less.

Furthermore, it is preferable that the micropores are each configured with a large diameter portion that extends to a position at a depth of 10 nm to 1,000 nm from the surface of the anodic oxide film and a small diameter portion that is in communication with a bottom portion of the large diameter portion and extends to a position at a depth of 20 nm to 2,000 nm from a communicate position, an average diameter of the large diameter portion within the surface of the anodic oxide film is preferably 15 nm to 100 nm, and an average diameter of the small diameter portion at the communicate position is preferably 13 nm or less.

From the viewpoints of the ozone discoloration suppressiveness and visibility, the value of the lightness L* of the surface of the support on the side of the image-recording layer, that is, the value of the lightness L* of the surface of the support on the side of the image-recording layer (surface of the anodic oxide film on the side of the image-recording layer) in the L*a*b* color system is preferably 85 or less, more preferably 75 or less, still more preferably 50 or more and 72 or less, and particularly preferably 62 or more and 72 or less.

The lightness L* is measured using a color difference meter Spectro Eye manufactured by X-Rite, Incorporated.

Fig. 1 is a schematic cross-sectional view of an embodiment of an aluminum support 12a.

The aluminum support 12a has a laminated structure in which an aluminum plate 18 and an anodic oxide film 20a of aluminum (hereinafter, also simply called "anodic oxide film 20a") are laminated in this order. The anodic oxide film 20a in the aluminum support 12a is positioned closer to the image-recording layer side than the aluminum plate 18. That is, it is preferable that the lithographic printing plate precursor according to the present disclosure have at least an anodic oxide film and an image-recording layer in this order on an aluminum plate.

-Anodic oxide film-

Hereinafter, preferred aspects of the anodic oxide coating film 20a will be described.

The anodic oxide film 20a is a film prepared on a surface of the aluminum plate 18 by an anodization treatment. This film has uniformly distributed ultrafine micropores 22a approximately perpendicular to the surface of the film. The micropores 22a extend from a surface of the anodic oxide film 20a on the image-recording layer side (a surface of the

anodic oxide film 20a opposite to the aluminum plate 18 side) along the thickness direction (toward the aluminum plate 18 side).

The average diameter (average opening diameter) of the micropores 22a on the surface of the anodic oxide film 20a is preferably more than 10 nm and 100 nm or less. Particularly, from the viewpoint of balance between printing durability, antifouling properties, and image visibility, the average diameter of the micropores 22a is more preferably 15 nm to 60 nm, even more preferably 20 nm to 50 nm, and particularly preferably 25 nm to 40 nm. The internal diameter of the pores may be larger or smaller than the pore diameter within the surface layer.

In a case where the average diameter is more than 10 nm, printing durability and image visibility are excellent. In addition, in a case where the average diameter is 100 nm or less, printing durability is excellent.

The average diameter of the micropores 22a is a value determined by observing the surface of the anodic oxide film 20a with a field emission scanning electron microscope (FE-SEM) at 150,000X magnification (N = 4), measuring the size (diameter) of 50 micropores existing in a range of 400 nm $\times$ 600 nm in the obtained 4 images, and averaging the measured sizes.

In a case where the shape of the micropores 22a is not circular, the equivalent circular diameter is used. "Equivalent circular diameter" is a diameter determined on an assumption that the opening portion is in the form of a circle having the same projected area as the projected area of the opening portion.

The shape of the micropores 22a is not particularly limited. In Fig. 1, the micropores 22a have a substantially straight tubular shape (substantially cylindrical shape). However, the micropores 22a may have a conical shape that tapers along the depth direction (thickness direction). In addition, the shape of the bottom portion of the micropores 22a is not particularly limited, and may be a curved (convex) or planar shape.

In the support, the micropores may be each composed of a large diameter portion that extends to a position at a certain depth from the surface of the anodic oxide film and a small diameter portion that is in communication with a bottom portion of the large diameter portion and extends to a position at a certain depth from the communicate position.

For example, as shown in Fig. 2, an aspect may be adopted in which an aluminum support 12b includes an aluminum plate 18 and an anodic oxide film 20b having micropores 22b each composed of a large diameter portion 24 and a small diameter portion 26.

For example, the micropores 22b in the anodic oxide film 20b are each composed of the large diameter portion 24 that extends to a position at a depth of 10 nm to 1,000 nm (depth D: see Fig. 2) from the surface of the anodic oxide film and the small diameter portion 26 that is in communication with the bottom portion of the large diameter portion 24 and further extends from the communicate position to a position at a depth of 20 nm to 2,000 nm. Specifically, for example, it is possible to use the aspect described in paragraphs "0107" to "0114" of JP2019-162855A.

-Manufacturing method of support-

As a manufacturing method of the support used in the present disclosure, for example, a manufacturing method is preferable in which the following steps are sequentially performed.

. Roughening treatment step: step of performing roughening treatment on aluminum plate
. Anodization treatment step: step of subjecting aluminum plate having undergone roughening treatment to anodic oxidation
. Pore widening treatment step: step of bringing aluminum plate having anodic oxide film obtained by anodization treatment step into contact with an aqueous acid solution or an aqueous alkali solution such that diameter of micropores in anodic oxide film increases

Hereinafter, the procedure of each step will be specifically described.

<<Roughening treatment step>>

The roughening treatment step is a step of performing a roughening treatment including an electrochemical roughening treatment on the surface of the aluminum plate. This step is preferably performed before the anodization treatment step which will be described later. However, in a case where the surface of the aluminum plate already has a preferable shape, the roughening treatment step may not be performed. This step can be carried out by the method described in paragraphs "0086" to "0101" of JP2019-162855A.

<<Anodization treatment step>>

The procedure of the anodization treatment step is not particularly limited as long as the aforementioned micropores can be obtained. Examples thereof include known methods.

In the anodization treatment step, an aqueous solution of sulfuric acid, phosphoric acid, oxalic acid, or the like can be used as an electrolytic cell. For example, the concentration of sulfuric acid is 100 g/L to 300 g/L.
The conditions of the anodization treatment are appropriately set depending on the electrolytic solution used. For example, the liquid temperature is 5°C to 70°C (preferably 10°C to 60°C), the current density is 0.5 A/dm$^2$ to 60 A/dm$^2$ (preferably 1 A/dm$^2$ to 60 A/dm$^2$), the voltage is 1 V to 100 V (preferably 5 V to 50 V), the electrolysis time is 1 second to 100 seconds (preferably 5 seconds to 60 seconds), and the film amount is 0.1 g/m$^2$ to 5 g/m$^2$ (preferably 0.2 g/m$^2$ to 3 g/m$^2$).

<<Pore widening treatment>>

The pore widening treatment is a treatment of enlarging the diameter of micropores (pore diameter) present in the anodic oxide film formed by the aforementioned anodization treatment step (pore diameter enlarging treatment).
The pore widening treatment can be carried out by bringing the aluminum plate obtained by the aforementioned anodization treatment step into contact with an aqueous acid solution or an aqueous alkali solution. The contact method is not particularly limited, and examples thereof include a dipping method and a spraying method.
As necessary, the support may have a backcoat layer on the side opposite to the image-recording layer, the backcoat layer containing the organic polymer compound described in JP1993-045885A (JP-H5-45885A) or the alkoxy compound of silicon described in JP1994-035174A (JP-H6-35174A).

<Outermost layer>

The lithographic printing plate precursor according to the present disclosure may have an outermost layer (also called "protective layer" or "overcoat layer" in some cases) on a surface of the image-recording layer that is opposite to the support side.
It is preferable that the lithographic printing plate precursor according to the present disclosure have a support, an image-recording layer, and an outermost layer in this order.
The film thickness of the outermost layer is preferably larger than the film thickness of the image-recording layer.
The outermost layer may have a function of suppressing the reaction inhibiting image formation by blocking oxygen, a function of preventing the damage of the image-recording layer, and a function of preventing ablation during exposure to high-illuminance lasers.
The outermost layer having such characteristics is described, for example, in US3458311A and JP1980-49729B (JP-S55-49729B). As polymers with low oxygen permeability that are used in the outermost layer, any of water-soluble polymers and water-insoluble polymers can be appropriately selected. As necessary, two or more types of such polymers can be used by being mixed together. From the viewpoint of on-press developability, the polymers with low oxygen permeability preferably include a water-soluble polymer.
In the present disclosure, a water-soluble polymer means a polymer having a solubility of more than 5% by mass in water at 25°C.
Examples of the water-soluble polymer used in the outermost layer include polyvinyl alcohol, modified polyvinyl alcohol, polyvinylpyrrolidone, a cellulose derivative, polyethylene glycol, poly(meth)acrylonitrile, and the like.
In addition, the hydrophilic polymer preferably includes at least one selected from the group consisting of a modified polyvinyl alcohol and a cellulose derivative.
As the modified polyvinyl alcohol, acid-modified polyvinyl alcohol having a carboxy group or a sulfo group is preferably used. Specific examples thereof include modified polyvinyl alcohols described in JP2005-250216A and JP2006-259137A.
Examples of the cellulose derivative include methyl cellulose, hydroxypropyl methyl cellulose, carboxymethyl cellulose, and the like.
Among the above water-soluble polymers, a polymer containing polyvinyl alcohol is preferable, and a polymer containing polyvinyl alcohol having a saponification degree of 50% or more is more preferable.
The saponification degree is preferably 60% or more, more preferably 70% or more, and even more preferably 85% or more. The upper limit of the saponification degree is not particularly limited, and may be 100% or less.
The saponification degree is measured according to the method described in JIS K 6726: 1994.
As an aspect of the outermost layer, for example, an aspect in which the outermost layer contains polyvinyl alcohol and polyethylene glycol is also preferable.
In a case where the outermost layer in the present disclosure contains a water-soluble polymer, the content of the water-soluble polymer with respect to the total mass of the outermost layer is preferably 1% by mass to 99% by mass, more preferably 3% by mass to 97% by mass, and even more preferably 5% by mass to 95% by mass.
The outermost layer preferably contains a hydrophobic polymer.
The hydrophobic polymer refers to a polymer that dissolves less than 5 g or does not dissolve in 100 g of pure water at 125°C.

Examples of the hydrophobic polymer include polyethylene, polystyrene, polyvinyl chloride, polyvinylidene chloride, polyalkyl (meth)acrylate ester (for example, polymethyl (meth)acrylate, polyethyl (meth)acrylate, polybutyl (meth)acrylate, and the like), a copolymer obtained by combining raw material monomers of these resins, and the like.

In addition, the hydrophobic polymer preferably includes a polyvinylidene chloride resin.

Furthermore, the hydrophobic polymer preferably includes a styrene-acrylic copolymer (also called styrene acrylic resin).

Furthermore, from the viewpoint of on-press developability, the hydrophobic polymer is preferably hydrophobic polymer particles.

Only one type of hydrophobic polymer may be used, or two or more types of hydrophobic polymers may be used in combination.

In a case where the outermost layer contains a hydrophobic polymer, the content of the hydrophobic polymer with respect to the total mass of the outermost layer is preferably 1% by mass to 70% by mass, more preferably 5% by mass to 50% by mass, and even more preferably 10% by mass to 40% by mass.

In the present disclosure, the proportion of the area of the hydrophobic polymer occupying the surface of the outermost layer is preferably 30 area% or higher, more preferably 40 area% or higher, and even more preferably 50 area% or higher.

The upper limit of the proportion of the area of the hydrophobic polymer occupying the surface of the outermost layer is, for example, 90 area%.

The proportion of the area of the hydrophobic polymer occupying the surface of the outermost layer can be measured as follows.

By using PHI nano TOFII time-of-flight secondary ion mass spectrometer (TOF-SIMS) manufactured by ULVAC-PHI, INCORPORATED., the surface of the outermost layer is irradiated with Bi ion beams (primary ions) at an acceleration voltage of 30 kV, and the peak of ions (secondary ions) corresponding to a hydrophobic portion (that is, a region formed of the hydrophobic polymer) that are emitted from the surface is measured so that the hydrophobic portion is mapped. By measuring the area of the hydrophobic portion in an area of 100 $\mu m^2$, the proportion of the area occupied by the hydrophobic portion is determined and adopted as "proportion of the area of the hydrophobic polymer occupying the surface of the outermost layer".

For example, in a case where the hydrophobic polymer is an acrylic resin, the proportion is measured using the peak of $C_6H_{13}O^-$. In addition, in a case where the hydrophobic polymer is polyvinylidene chloride, the proportion is measured using the peak of $C_2H_2Cl^+$.

The proportion of occupied area can be adjusted by the additive amount of the hydrophobic polymer or the like.

From the viewpoint of visibility and storage stability, the outermost layer preferably contains an infrared absorber, and more preferably contains a decomposition-type infrared absorber.

As the infrared absorber, for example, those mentioned above regarding the image-recording layer are suitable.

In the outermost layer, one type of infrared absorber may be used alone, or two or more types of infrared absorbers may be used in combination.

From the viewpoint of temporal visibility and storage stability, the content of the infrared absorber in the outermost layer with respect to the total mass of the outermost layer is preferably 0.10% by mass to 50% by mass, more preferably 0.50% by mass to 30% by mass, and even more preferably 1.0% by mass to 20% by mass.

From the viewpoint of improving the visibility of exposed portions, the outermost layer preferably contains a color forming agent.

As the color forming agent, for example, those mentioned above regarding the image-recording layer are suitable.

In the outermost layer, one type of color forming agent may be used alone, or two or more types of color forming agents may be used in combination.

From the viewpoint of color formability, the content of the color forming agent in the outermost layer with respect to the total mass of the outermost layer is preferably 0.10% by mass to 50% by mass, more preferably 0.50% by mass to 30% by mass, and even more preferably 1.0% by mass to 20% by mass.

In order to improve oxygen barrier properties, the outermost layer may contain an inorganic lamellar compound. The inorganic lamellar compound refers to particles in the form of a thin flat plate, and examples thereof include mica groups such as natural mica and synthetic mica, talc represented by Formula $3MgO \cdot 4SiO \cdot H_2O$, taeniolite, montmorillonite, saponite, hectorite, zirconium phosphate, and the like.

As the inorganic lamellar compound, a mica compound is preferably used. Examples of the mica compound include mica groups such as natural mica and synthetic mica, which are represented by Formula: $A(B, C)_{2\text{-}5}D_4O_{10}(OH, F, O)_2$ [here, A represents any of K, Na, and Ca, B and C represent any of Fe (II), Fe (III), Mn, Al, Mg, and V, and D represents Si or Al.].

In the mica group, examples of the natural mica include muscovite, soda mica, phlogopite, biotite, and lepidolite. Examples of synthetic mica include non-swelling mica such as fluorine phlogopite $KMg_3(AlSi_3O_{10})F_2$, potassium tetrasilic

mica $KMg_{2.5}Si_4O_{10})F_2$, and, Na tetrasilylic mica $NaMg_{2.5}(Si_4O_{10})F_2$, swelling mica such as Na or Li taeniolite (Na, Li) $Mg_2Li(Si_4O_{10})F_2$, montmorillonite-based Na or Li hectorite (Na, Li)$_{1/8}$$Mg_{2/5}Li_{1/8}(Si_4O_{10})F_2$. Furthermore, synthetic smectite is also useful.

Among the mica compounds, fluorine-based swelling mica is particularly useful. That is, swelling synthetic mica has a laminated structure consisting of unit crystal lattice layers having a thickness in a range of about 10Å to 15Å (1Å is equal to 0.1 nm), and metal atoms in lattices are more actively substituted than in any other clay minerals. As a result, positive charges are deficient in the lattice layers, and positive ions such as $Li^+$, $Na^+$, $Ca^{2+}$, and $Mg^{2+}$ are absorbed between the layers in order to compensate for the deficiency. Positive ions interposed between the layers are referred to as exchangeable positive ions and are exchangeable with various positive ions. Particularly, in a case where the positive ions between the layers are $Li^+$ and $Na^+$, the ionic radii are small, and thus the bonds between lamellar crystal lattices are weak, and mica is significantly swollen by water. In a case where shearing is applied in this state, mica easily cleavages and forms a stable sol in water. Swelling synthetic mica is particularly preferably used because it clearly exhibits such a tendency.

From the viewpoint of diffusion control, regarding the shapes of the mica compounds, the thickness is preferably thin, and the planar size is preferably large as long as the smoothness and actinic ray-transmitting property of coated surfaces are not impaired. As a result, the aspect ratio is preferably 20 or more, more preferably 100 or more, and particularly preferably 200 or more. The aspect ratio is the ratio of the major diameter to the thickness of a particle, and it can be measured, for example, from a projection view obtained from the microphotograph of the particle. As the aspect ratio increases, the obtained effect is stronger.

Regarding the particle diameter of the mica compound, the average major diameter thereof is preferably 0.3 μm to 20 μm, more preferably 0.5 μm to 10 μm, and particularly preferably 1 μm to 5 μm. The average thickness of the particles is preferably 0.1 μm or less, more preferably 0.05 μm or less, and particularly preferably 0.01 μm or less. Specifically, for example, as a preferable aspect of swelling synthetic mica which is a representative compound, the thickness thereof is in a range of about 1 nm to 50 nm and the surface size (major diameter) is in a range of about 1 μm to 20 μm.

The content of the inorganic lamellar compound with respect to the total mass of the outermost layer is preferably 1% by mass to 60% by mass, and more preferably 3% by mass to 50% by mass. Even in a case where two or more inorganic lamellar compounds are used in combination, the total amount of the inorganic lamellar compounds preferable equals the content described above. In a case where the content is within the above range, the oxygen barrier property is improved, and excellent sensitivity is obtained. In addition, the deterioration of receptivity can be prevented.

The outermost layer may contain known additives such as a plasticizer for imparting flexibility, a surfactant for improving coating properties, and inorganic particles for controlling surface sliding properties. In addition, the oil sensitizing agent described above regarding the image-recording layer may be incorporated into the outermost layer.

The outermost layer is formed by known coating methods. The coating amount of the outermost layer (solid content) is preferably 0.01 $g/m^2$ to 10 $g/m^2$, more preferably 0.02 $g/m^2$ to 3 $g/m^2$, and particularly preferably 0.02 $g/m^2$ to 1 $g/m^2$.

The film thickness of the outermost layer in the lithographic printing plate precursor according to the present disclosure is preferably 0.1 μm to 5.0 μm, and more preferably 0.3 μm to 4.0 μm.

The film thickness of the outermost layer in the lithographic printing plate precursor according to the present disclosure/film thickness of the image-recording layer is preferably 1.1/1 to 5.0/1, and more preferably 1.5/1 to 3.0/1.

The lithographic printing plate precursor according to the present disclosure may have other layers in addition to those mentioned above.

Known layers can be adopted as those other layers without particular limitations. For example, as necessary, a backcoat layer may be provided on a surface of the support that is opposite to the image-recording layer side.

(Method of preparing lithographic printing plate and lithographic printing method)

Although the method of preparing a lithographic printing plate according to the present disclosure is not particularly limited, but it is preferable that the method of preparing a lithographic printing plate include a step of exposing the lithographic printing plate precursor in the shape of an image (exposure step) and a step of removing the image-recording layer in a non-image area by supplying at least one selected from the group consisting of a printing ink and dampening water to the lithographic printing plate precursor having undergone exposure on a printer (on-press development step).

The lithographic printing method according to the present disclosure preferably includes a step of exposing the lithographic printing plate precursor in the shape of an image (exposure step), a step of removing the image-recording layer in a non-image area by supplying at least one selected from the group consisting of a printing ink and dampening water on a printer to prepare a lithographic printing plate (on-press development step), and a step of performing printing by using the obtained lithographic printing plate (hereinafter, also called "printing step").

<Exposure step>

The method of preparing a lithographic printing plate according to the present disclosure preferably includes an exposure step of exposing the lithographic printing plate precursor in the shape of an image to form an exposed portion and a non-exposed portion. The lithographic printing plate precursor according to the present disclosure is preferably exposed to a laser through a transparent original picture having a linear image, a halftone dot image, or the like or exposed in the shape of an image by laser light scanning according to digital data, or the like.

The wavelength of a light source to be used is preferably 750 nm to 1,400 nm. As the light source having a wavelength of 750 nm to 1,400 nm, a solid-state laser or a semiconductor laser that radiates infrared is suitable. In a case where an infrared laser is used, the output is preferably 100 mW or more, the exposure time per pixel is preferably 20 microseconds or less, and the amount of irradiation energy is preferably 10 $mJ/cm^2$ to 300 $mJ/cm^2$. In addition, in order to shorten the exposure time, a multibeam laser device is preferably used. The exposure mechanism may be any of an inner surface drum method, an external surface drum method, a flat head method, or the like.

The image exposure can be carried out by a common method using a platesetter or the like. In the case of on-press development, image exposure may be carried out on a printer after the lithographic printing plate precursor is mounted on the printer.

<On-press development step>

The method of preparing a lithographic printing plate according to the present disclosure preferably includes an on-press development step of removing the image-recording layer in a non-image area by supplying at least one selected from the group consisting of printing ink and dampening water on a printer.

Hereinafter, the on-press development method will be described.

[On-press development method]

In the on-press development method, the lithographic printing plate precursor having undergone image exposure is preferably supplied with an oil-based ink and an aqueous component on a printer such that the image-recording layer in a non-image area is removed and a lithographic printing plate is prepared.

That is, in a case where the lithographic printing plate precursor is subjected to image exposure and then mounted as it is on a printer without being subjected to any development treatment, or the lithographic printing plate precursor is mounted on a printer and then subjected to image exposure on the printer, and then an oil-based ink and an aqueous component are supplied to perform printing, at the initial stage in the middle of printing, in a non-image area, by either or both of the supplied oil-based ink and the aqueous component, a non-cured image-recording layer is dissolved or dispersed to remove, and the hydrophilic surface is exposed in the non-image area. Meanwhile, the image-recording layer cured by exposure forms an oil-based ink-receiving area having a lipophilic surface in the exposed portion. What is supplied first to the precursor surface may be any of the oil-based ink or the aqueous component. However, in view of preventing the plate from being contaminated by the components of the image-recording layer from which aqueous components are removed, it is preferable that the oil-based ink be supplied first. In the manner described above, the lithographic printing plate precursor is subjected to on-press development on a printer and used as it is for printing a number of sheets. As the oil-based ink and the aqueous component, ordinary printing ink and ordinary dampening water for lithographic printing are suitably used.

<Printing step>

The lithographic printing method according to the present disclosure includes a printing step of printing a recording medium by supplying a printing ink to the lithographic printing plate.

The printing ink is not particularly limited, and various known inks can be used as desired. In addition, preferred examples of the printing ink include oil-based ink or ultraviolet-curable ink (UV ink).

In the printing step, as necessary, dampening water may be supplied.

In addition, the printing step may be successively carried out after the on-press development step or the development step using a developer, without stopping the printer.

The recording medium is not particularly limited, and a known recording medium can be used as desired.

In the method of preparing a lithographic printing plate and the lithographic printing method according to the present disclosure, as necessary, the entire surface of the lithographic printing plate precursor may be heated before exposure, in the middle of exposure, or during a period of time from exposure to development. In a case where the lithographic printing plate precursor is heated as above, an image-forming reaction in the image-recording layer is accelerated, which can result in advantages such as improvement of sensitivity and printing durability, and stabilization of

sensitivity. Heating before development is preferably carried out under a mild condition of 150°C or lower. In a case where this aspect is adopted, it is possible to prevent problems such as curing of a non-image area. For heating after development, it is preferable to use an extremely severe condition which is preferably in a range of 100°C to 500°C. In a case where this aspect is adopted, a sufficient image-strengthening action is obtained, and it is possible to inhibit problems such as the deterioration of the support or the thermal decomposition of the image area.

Examples

Hereinafter, the present disclosure will be described in detail with reference to examples, but the present disclosure is not limited thereto. In the present examples, unless otherwise specified, "%" and "part" mean "% by mass" and "part by mass" respectively. Unless otherwise described, the molecular weight of a high-molecular-weight compound is a weight-average molecular weight (Mw), and the ratio of repeating constitutional units of a polymer compound is expressed as molar percentage. In addition, the weight-average molecular weight (Mw) is a polystyrene-equivalent molecular weight measured by gel permeation chromatography (GPC).

(Examples 1 to 17 and Comparative Examples 1 to 8)

(1) Production of support A: (MGV)

«Mechanical roughening treatment (brush graining method)»

A pumice suspension (specific gravity: 1.1 g/$cm^3$) as an abrasive slurry was supplied to the surface of an aluminum plate, and in this state, a mechanical roughening treatment is performed using a rotating bundled brush to grain the surface of an aluminum plate. In the mechanical roughening treatment, an abrasive having a median diameter (μm) of 30 μm and 4 brushes were used, and the rotation speed (revolutions per minute (rpm)) of the brushes was set to 250 rpm. The bundled brush was made of 6·10 nylon and consisted of bristles having a diameter of 0.3 mm and a length of 50 mm. The brush was prepared by making holes in a ϕ 300 mm stainless steel cylinder and densely implanting bristles therein. The distance between two support rollers (ϕ 200 mm) under the bundled brush was 300 mm. The bundled brush was pressed until the load of the drive motor for rotating the brush was 10 kW higher than the load applied before the bundled brush was pressed on the aluminum plate. The rotation direction of the brush was the same as the moving direction of the aluminum plate.

«Alkaline etching treatment>>

The aluminum plate obtained in the above-described manner was subjected to an etching treatment by spraying a caustic soda aqueous solution in which the concentration of caustic soda was 26% by mass and the concentration of aluminum ions was 6.5% by mass using a spray at a temperature of 70°C. Then, water washing was performed by means of spraying. The amount of dissolved aluminum was 6 g/$m^2$.

<<Desmutting treatment using acidic aqueous solution»

Next, a desmutting treatment was performed using an aqueous nitric acid solution. Specifically, the desmutting treatment was performed for 3 seconds by spraying the aqueous nitric acid solution onto the aluminum plate. As the aqueous nitric acid solution used for the desmutting treatment, a waste liquid of nitric acid used for the subsequent electrochemical roughening treatment step was used. The liquid temperature was 35°C.

«Electrochemical roughening treatment>>

An electrochemical roughening treatment was continuously performed using an AC voltage of 60 Hz in nitric acid electrolysis. As an electrolytic solution at this time, an electrolytic solution which had been adjusted to have a concentration of aluminum ions of 4.5 g/L by adding aluminum nitrate to a nitric acid aqueous solution having a concentration of 10.4 g/L at a liquid temperature of 35°C was used. By using an alternating current power source having the waveform shown in Fig. 3, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 4 was used. The current density was 30 A/$dm^2$ in terms of the peak value of current, and 5% of the current coming from the power source was allowed to flow into the auxiliary anode. The electricity quantity (C/$dm^2$) was 185 C/$dm^2$, which is the total quantity of electricity used during the anodic reaction of the aluminum plate. Then, water washing was

performed by means of spraying.

«Alkaline etching treatment>>

The aluminum plate obtained in the above-described manner was subjected to an etching treatment by spraying a caustic soda aqueous solution in which the concentration of caustic soda was 27% by mass and the concentration of aluminum ions was 2.5% by mass using a spray at a temperature of 45°C. Then, water washing was performed by means of spraying.

Changing the temperature in the alkaline etching treatment makes it possible to control the etching amount of aluminum of a surface subjected to a roughening treatment and to adjust the L value of the support.

<<Desmutting treatment using acidic aqueous solution»

Next, a desmutting treatment was performed using an aqueous sulfuric acid solution. Specifically, the desmutting treatment was performed for 3 seconds by spraying the aqueous sulfuric acid solution onto the aluminum plate. As the aqueous sulfuric acid solution used for the desmutting treatment, an aqueous solution having a sulfuric acid concentration of 170 g/L and an aluminum ion concentration of 5 g/L was used. The liquid temperature was 30°C.

«Electrochemical roughening treatment>>

An electrochemical roughening treatment was continuously performed using an AC voltage of 60 Hz in hydrochloric acid electrolysis. An electrolytic solution at a liquid temperature of 35°C was used which was prepared by adding aluminum chloride to 6.2 g/L aqueous hydrochloric acid solution such that the aluminum ion concentration was adjusted to 4.5 g/L. By using an alternating current power source having the waveform shown in Fig. 3, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 4 was used. The current density was 25 A/dm$^2$ in terms of the peak value of current, and the quantity of electricity (C/dm$^2$) during the hydrochloric acid electrolysis was 63 C/dm$^2$ which is the total quantity of electricity used during the anodic reaction of the aluminum plate. Then, water washing was performed by means of spraying.

<<Desmutting treatment using acidic aqueous solution»

Next, a desmutting treatment was performed using an aqueous sulfuric acid solution. Specifically, the desmutting treatment was performed for 3 seconds by spraying the aqueous sulfuric acid solution onto the aluminum plate. As the aqueous sulfuric acid solution used for the desmutting treatment, a waste liquid generated in the anodization treatment step (an aqueous solution having a sulfuric acid concentration of 170 g/L and an aluminum ion concentration of 5 g/L) was used. The liquid temperature was 35°C.

<<First-stage anodization treatment>>

By using the anodization device for direct current electrolysis, a first-stage anodization treatment was performed to form an anodic oxide film having a film thickness of 110 nm.

<<Pore widening treatment>>

The aluminum plate having undergone the above anodization treatment was immersed in an aqueous solution of caustic soda at a temperature of 40°C and having a caustic soda concentration of 5% by mass and an aluminum ion concentration of 0.5% by mass for 2.7 seconds, thereby performing a pore widening treatment. Then, water washing was performed by means of spraying.

<<Second-stage anodization treatment>>

By using the anodization device for direct current electrolysis, a second-stage anodization treatment was performed to form an anodic oxide film having a film thickness of 1,500 nm and to prepare the support A.

<Formation of undercoat layer>

An aqueous solution for a undercoat layer adjusted to have the following composition and a pH shown in Table 1 by ethylenediaminetetraacetic acid and a sodium salt thereof (a solid content of 1% by mass) was applied onto the support A such that the content of each component in the undercoat layer after drying was the content shown in Table 1, to form an undercoat layer.

-Aqueous solution for undercoat layer-

· Polymer having an ethylenically unsaturated group, shown in Table 1: an amount corresponding to the dry coating amount shown in Table 1
· Water-soluble monofunctional monomer, shown in Table 1: an amount corresponding to the dry coating amount shown in Table 1
· Surfactant (polyoxyethylene lauryl ether): an amount corresponding to the dry coating amount of 4.0 $mg/m^2$
· Preservative: BIOHOPE manufactured by K.I Chemical Industry Co., LTD.: an amount corresponding to the dry coating amount of 0.75 $mg/m^2$

<Formation of image-recording layer>

The undercoat layer was bar-coated with the following image-recording layer coating liquid 1 and dried in the oven at 120°C for 40 seconds, thereby forming an image-recording layer having a dried coating amount of 1.0 $g/m^2$ and thus obtaining a lithographic printing plate precursor of each of Examples and Comparative Examples.

In Example 11 and Comparative Example 5, the components shown in Table 1 were further added such that the content in the image-recording layer after drying was the content shown in Table 1, thereby preparing the image-recording layer coating liquid 1.

-Image-recording layer coating liquid 1-

The following components were dissolved and dispersed in a mixed solvent of 1-methoxy-2-propanol (MFG):methyl ethyl ketone (MEK):methanol = 4:4:1 (mass ratio), and the solid content was prepared to 6% by mass, thereby preparing an image-recording layer coating liquid 1.

· Infrared absorber IR Dye-1 (the following compound): an amount such that the content in the image-recording layer after drying is 40 $mg/m^2$
· Polymerization initiator IA-1 (the following compound, LUMO = -3.02 eV): 100 parts by mass
· Auxiliary TPB (sodium tetraphenylborate, HOMO = -5.90 eV) capable of donating an electron to the infrared absorber: an amount such that the content in the image-recording layer after drying is the amount shown in Table 1
· Polymerizable compound M-1 (urethane (meth)acrylate oligomer, U-10HA (number of functional groups: 10), manufactured by SHIN-NAKAMURA CHEMICAL CO., LTD.): 500 parts by mass
· Color forming agent precursor 1 (the following Leuco-1): 25 parts by mass
· Anionic surfactant A-1 (compound having the following structure): 25 parts by mass
· Fluorine-based surfactant W-1 (compound having the following structure, weight-average molecular weight: 13,000): 5 parts by mass

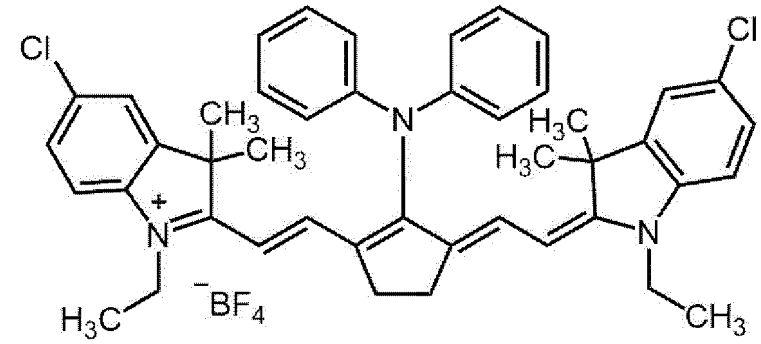

IR Dye - 1

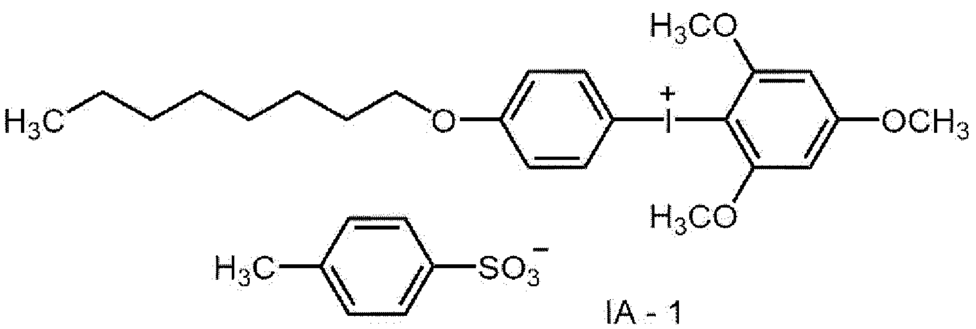

IA - 1

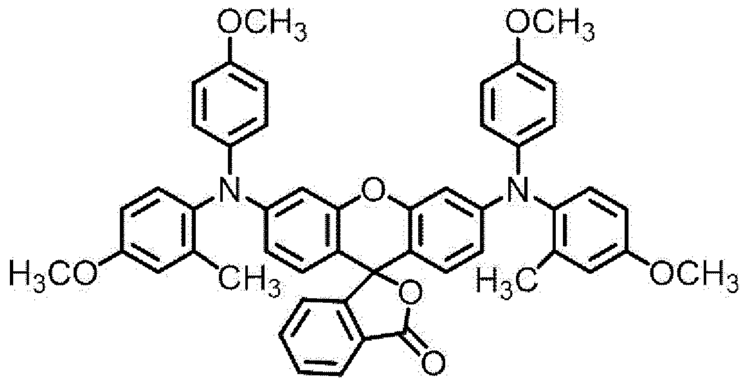

Leuco - 1

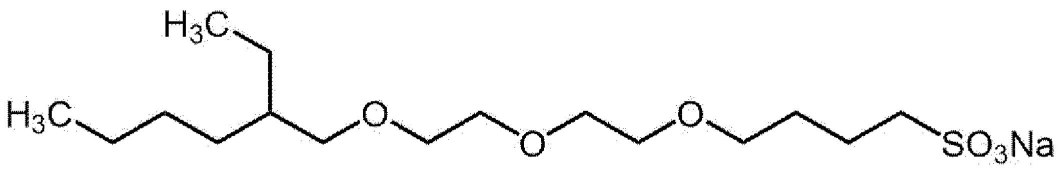

A - 1

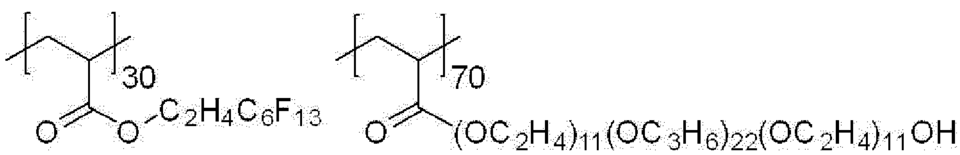

W - 1
Mw = 13,000

<Formation of outermost layer>

The image-recording layer was bar-coated with the following outermost layer coating liquid 1 and dried in an oven at 120°C for 60 seconds, thereby forming an outermost layer having a dry coating amount of 0.2 $g/m^2$.

-Preparation of outermost layer coating liquid 1-

The outermost layer coating liquid 1 contained the following components at the following mass ratios, and the solid content was prepared to 6% by mass with ion exchange water. The following additive amount indicates the amount of solid.

Hydrophilic polymer WP-6: 60 parts
Hydrophobic polymer L-3: 20 parts
Surfactant F-1: 5 parts

[Hydrophilic polymer]

WP-6: Cellulose, METOLOSE SM04 manufactured by Shin-Etsu Chemical Co., Ltd.

[Hydrophobic polymer]

L-3: Styrene-acrylic resin, FS-102 manufactured by Nippon paint Industrial Coatings Co., LTD.

[Surfactant]

F-1: Anionic surfactant, RAPISOL A-80, manufactured by NOF CORPORATION

<Evaluation>

-Temporal on-press developability-

The obtained lithographic printing plate precursor was humidified for 1 hour in an environment at 25°C and 60 % RH. Thirty sheets of the lithographic printing plate precursors including interleaving paper interposed therebetween were laminated, and the obtained laminate was packaged with kraft aluminum vapor-deposited paper. The gap was completely stopped up with a gummed tape to prevent outside air from entering and to make an airtight state. Then, the packaged laminate was left to stand for 7 days in a thermostatic chamber at a temperature set to 55°C. The sample was taken out from the thermostatic chamber and allowed to stand until it was cooled to 25°C. After cooling to 25°C, the packaging was unsealed, and using a lithographic printing plate precursor in the middle (15th sheet), the temporal on-press developability was evaluated based on the following evaluation standard.

5: number of sheets of development completion, less than 20
4: number of sheets of development completion, 20 or more and less than 25
3: number of sheets of development completion, 25 or more and less than 30
2: number of sheets of development completion, 30 or more and less than 35
1: number of sheets of development completion, 35 or more

-Printing durability-

In Luxel PLATESETTER T-6000III manufactured by FUJIFILM Corporation that was equipped with an infrared semiconductor laser, the obtained lithographic printing plate precursor was exposed under the conditions of an outer drum rotation speed of 1,000 rpm, a laser output of 70%, and resolution of 2,400 dpi. The exposure image included a solid image and a 50% halftone dot chart of a 20 μm dot frequency modulation (FM) screen.

The obtained exposed lithographic printing plate precursor was mounted to the plate cylinder of a printer LITHRONE26 (manufactured by KOMORI Corporation) without performing a development treatment. By using dampening water containing Ecolity-2 (manufactured by FUJIFILM Corporation)/tap water = 2/98 (volume ratio) and Values-G(N) black ink (manufactured by DIC Corporation), on-press development was performed by supplying the dampening water and ink according to the standard automatic printing start method of LITHRONE26. Thereafter, printing was performed on 100 sheets of TOKUBISHI ART (ream weight: 76.5 kg, manufactured by MITSUBISHI PAPER MILLS LIMITED.) at a

printing rate of 10,000 sheets/hour.

Furthermore, printing was continued, and based on the number of printed sheets at a point in time when it was visually confirmed that the density of the solid image began to decrease, printing durability was evaluated according to the following evaluation standard.

5: number of printed sheets, 75,000 or more
4: number of printed sheets, 65,000 or more and less than 75,000
3: number of printed sheets, 55,000 or more and less than 65,000
2: number of printed sheets, 45,000 or more and less than 55,000
1: number of printed sheets, less than 45,000

-Visibility-

<Measurement of lightness change ΔL before and after exposure>

In Luxel PLATESETTER T-9800 manufactured by FUJIFILM Graphic Systems that is equipped with an infrared semiconductor laser with a wavelength of 830 nm, the obtained lithographic printing plate precursor was exposed under the conditions of output of 99.5%, outer drum rotation speed of 220 rpm, and resolution of 2,400 dots per inch (dpi, 1 inch = 25.4 mm) (energy density of 110 mJ/$cm^2$). The exposure was carried out in an environment of 25°C and 50 %RH. The lightness change of the lithographic printing plate precursor before and after exposure was measured. The lightness change was measured using a spectrocolorimeter eXact manufactured by X-Rite, Incorporated. By using the L* value (lightness) in the L*a*b* color system, the absolute value of a difference between the L* value of the image-recording layer after the exposure and the L* value of the image-recording layer before the exposure was adopted as the lightness change ΔL.

The evaluation of visibility was performed based on the following evaluation standard.

4 points: ΔL was 7 or more.

3 points: ΔL was 5 or more and less than 7.

2 points: ΔL was 3 or more and less than 5.

1 point: ΔL was less than 3.

[Table 1]

| | Undercoat layer | | | | | | | | Image-recording layer | | | | | Evaluation result | | |
|---|---|---|---|---|---|---|---|---|---|---|---|---|---|---|---|---|
| | Polymer having ethylenically unsaturated group | | Water-soluble monofunctional monomer | | Ratio ($M^B$/$M^A$) | pH of coating liquid | Polymerization inhibitor | | Compound additionally added | | TPB | Color forming substance precursor | | Temporal on-press developability | Printing durability | Visibility |
| | Type | Additive amount (mg/$m^2$) | Type | Additive amount (mg/$m^2$) | | | Type | Additive amount (mg/$m^2$) | Type | Additive amount (mg/$m^2$) | Additive amount (mg/$m^2$) | Type | Additive amount (mg/$m^2$) | | | |
| Example 1 | Polymer 1 | 5 | A (monofunctional) | 30 | 6.0 | 6.5 | - | - | - | - | 20 | 1 | 25 | 5 | 3 | 3 |
| Example 2 | Polymer 1 | 7.5 | A (monofunctional) | 30 | 4.0 | 6.5 | - | - | - | - | 20 | 1 | 25 | 5 | 4 | 3 |
| Example 3 | Polymer 1 | 12.5 | A (monofunctional) | 30 | 2.4 | 6.5 | - | - | - | - | 20 | 1 | 25 | 5 | 5 | 3 |
| Example 4 | Polymer 1 | 12.5 | A (monofunctional) | 30 | 2.4 | 6.5 | - | - | - | - | - | 1 | 25 | 3 | 5 | 3 |
| Example 5 | Polymer 1 | 15 | A (monofunctional) | 30 | 2.0 | 6.5 | - | - | - | - | 20 | 1 | 25 | 4 | 5 | 3 |
| Example 6 | Polymer 1 | 30 | A (monofunctional) | 30 | 1.0 | 6.5 | - | - | - | - | 20 | 1 | 25 | 3 | 5 | 3 |
| Example 7 | Polymer 1 | 10 | A (monofunctional) | 8 | 0.8 | 6.5 | - | - | - | - | 20 | 1 | 25 | 2 | 5 | 3 |
| Example 8 | Polymer 1 | 10 | A (monofunctional) | 10 | 1.0 | 6.5 | - | - | - | - | 20 | 1 | 25 | 2 | 5 | 3 |
| Example 9 | Polymer 1 | 10 | A (monofunctional) | 20 | 2.0 | 6.5 | - | - | - | - | 20 | 1 | 25 | 4 | 5 | 3 |
| Example 10 | Polymer 1 | 12.5 | A (monofunctional) | 30 | 2.4 | 9.5 | - | - | - | - | 20 | 1 | 25 | 4 | 5 | 2 |
| Example 11 | Polymer 1 | 12.5 | A (monofunctional) | 30 | 2.4 | 3.5 | - | - | - | - | 20 | 1 | 25 | 5 | 4 | 4 |

(continued)

| | Undercoat layer | | | | | | | | Image-recording layer | | | | | Evaluation result | | |
|---|---|---|---|---|---|---|---|---|---|---|---|---|---|---|---|---|
| | Polymer having ethylenically unsaturated group | | Water-soluble monofunctional monomer | | Ratio ($M^B$/$M^A$) | pH of coating liquid | Polymerization inhibitor | | Compound additionally added | | TPB | Color forming substance precursor | | Temporal on-press developability | Printing durability | Visibility |
| | Type | Additive amount (mg/m²) | Type | Additive amount (mg/m²) | | | Type | Additive amount (mg/m²) | Type | Additive amount (mg/m²) | Additive amount (mg/m²) | Type | Additive amount (mg/m²) | | | |
| Example 12 | Polymer 1 | 12.5 | A (monofunctional) | 30 | 2.4 | 3.5 | - | - | - | - | 20 | 2 | 25 | 5 | 4 | 2 |
| Example 13 | Polymer 1 | 12.5 | - | - | - | 6.5 | - | - | A (monofunctional) | 30 | 20 | 1 | 25 | 4 | 4 | 3 |
| Example 14 | Polymer 2 | 12.5 | A (monofunctional) | 30 | 2.4 | 6.5 | - | - | - | - | 20 | 1 | 25 | 5 | 5 | 3 |
| Example 15 | Polymer 3 | 12.5 | A (monofunctional) | 30 | 2.4 | 6.5 | - | - | - | - | 20 | 1 | 25 | 5 | 5 | 3 |
| Example 16 | Polymer 1 | 12.5 | SR256 | 30 | 2.4 | 6.5 | - | - | - | - | 20 | 1 | 25 | 5 | 5 | 3 |
| Example 17 | Polymer 1 | 12.5 | β-CEA | 30 | 2.4 | 6.5 | - | - | - | - | 20 | 1 | 25 | 4 | 5 | 3 |
| Comparative Example 1 | - | - | A (monofunctional) | 30 | - | 6.5 | - | - | - | - | 20 | 1 | 25 | 5 | 1 | 3 |
| Comparative Example 2 | Polymer 1 | 12.5 | - | - | - | 6.5 | - | - | - | - | 20 | 1 | 25 | 1 | 5 | 3 |
| Comparative Example 3 | Polymer 1 | 12.5 | | 30 | 2.4 | 6.5 | - | - | - | - | 20 | 1 | 25 | 1 | 5 | 3 |

(continued)

| | Undercoat layer | | | | | | | | Image-recording layer | | | | | Evaluation result | | |
|---|---|---|---|---|---|---|---|---|---|---|---|---|---|---|---|---|
| | Polymer having ethylenically unsaturated group | | Water-soluble monofunctional monomer | | Ratio ($M^B$/$M^A$) | pH of coating liquid | Polymerization inhibitor | | Compound additionally added | | TPB | Color forming substance precursor | | Temporal on-press developability | Printing durability | Visibility |
| | Type | Additive amount (mg/m²) | Type | Additive amount (mg/m²) | | | Type | Additive amount (mg/m²) | Type | Additive amount (mg/m²) | Additive amount (mg/m²) | Type | Additive amount (mg/m²) | | | |
| Comparative Example 4 | Polymer 1 | 12.5 | - | - | - | 6.5 | OH-TEMPO | 30 | - | - | 20 | 1 | 25 | 5 | 1 | 3 |
| Comparative Example 5 | Polymer 1 | 12.5 | - | - | - | 6.5 | - | - | Phenothiazine | 30 | 20 | 1 | 25 | 5 | 1 | 3 |
| Comparative Example 6 | Polymer 1 | 12.5 | SR257 | 30 | 2.4 | 6.5 | - | - | - | - | 20 | 1 | 25 | 1 | 5 | 3 |
| Comparative Example 7 | Polymer 1 | 12.5 | SR610 NS | 30 | 2.4 | 6.5 | - | - | - | - | 20 | 1 | 25 | 1 | 5 | 3 |
| Comparative Example 8 | Polymer 1 | 12.5 | A (monofunctional) | 30 | 2.4 | 6.5 | - | - | - | - | 20 | - | - | 5 | 5 | 1 |

The additive amount of each component in Table 1 represents the content (mg/m$^2$) per unit area in each layer after drying.

In addition, "Ratio $M^B/M^A$" in Table 1 represents the ratio $M^B/M^A$ of the content $M^B$ of the water-soluble monofunctional monomer with respect to the content $M^A$ of the polymer having an ethylenically unsaturated group per unit area of the on-press development type lithographic printing plate precursor.

Details of each component used in Table 1 are as follows.

<Polymer having ethylenically unsaturated group>

Polymer 1: shown below (U-1)

(U-1)

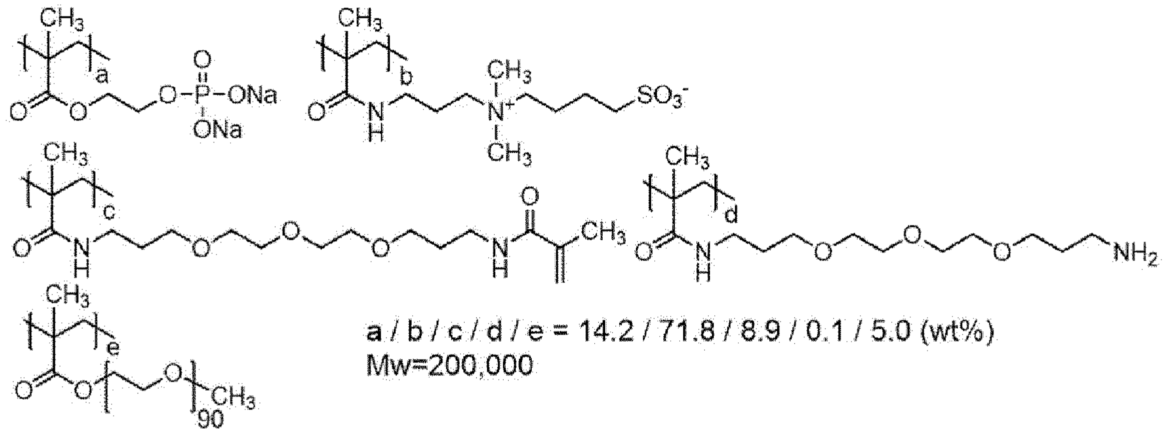

a / b / c / d / e = 14.2 / 71.8 / 8.9 / 0.1 / 5.0 (wt%)

Mw=200,000

Polymer 2: the following polymer

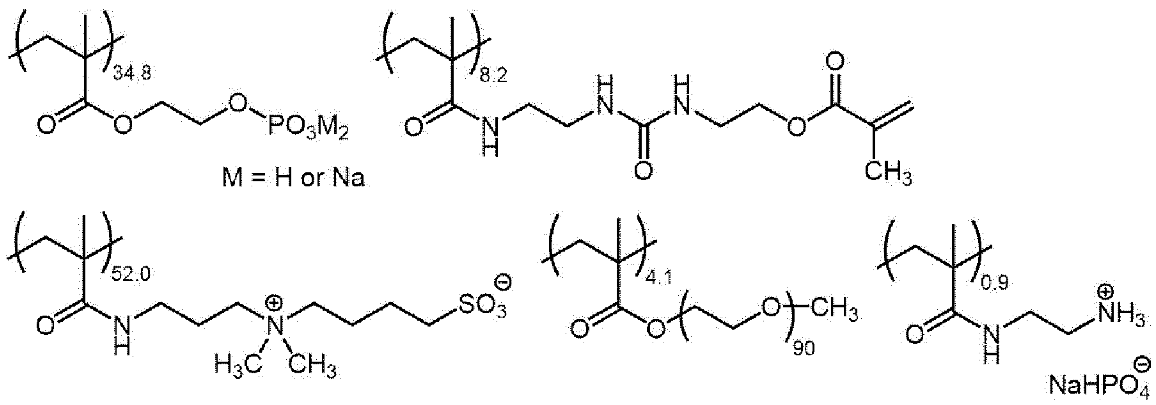

M = H or Na

Mw = 200,000

Polymer 3: the following polymer

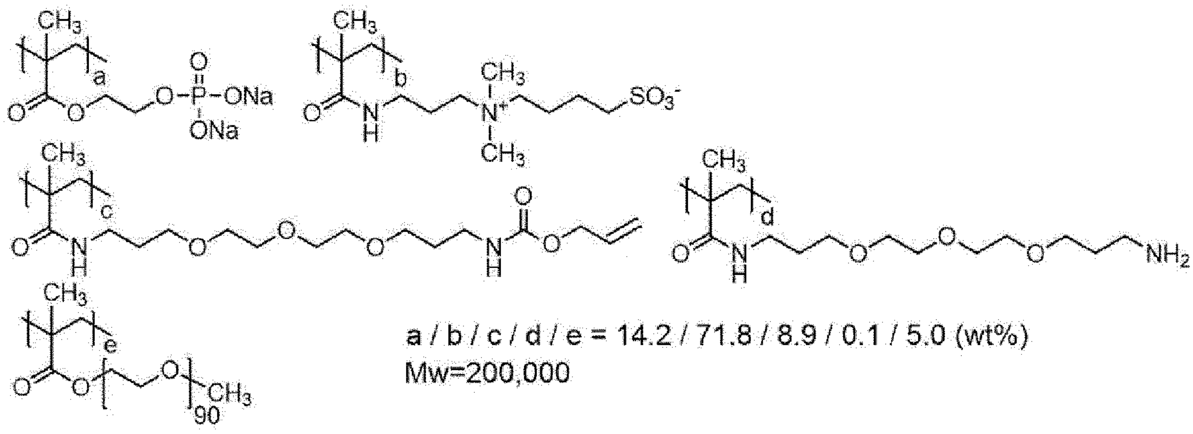

a / b / c / d / e = 14.2 / 71.8 / 8.9 / 0.1 / 5.0 (wt%)
Mw=200,000

<Water-soluble monofunctional monomer>

A (monofunctional): 2-methacryloyloxyethyl acid phosphate, Light Ester P-1M manufactured by KYOEISHA CHEMICAL Co., Ltd.

SR256: 2-(2-ethoxyethoxy)ethyl acrylate, manufactured by Arkema S.A.
β-CEA: β-carboxyethyl acrylate, manufactured by DAICEL-ALLNEX Ltd.

<Monomer for comparison>

B (difunctional): triethylene glycol dimethacrylate, a water-soluble difunctional monomer, Light Ester 3EG manufactured by KYOEISHA CHEMICAL Co., Ltd.
SR257: stearyl acrylate, a water-insoluble monofunctional monomer, manufactured by Arkema S.A.
SR610 NS: polyethylene glycol (600) diacrylate, a water-soluble difunctional monomer, manufactured by Arkema S.A.

<Polymerization inhibitor>

OH-TEMPO: 4-hydroxy-2,2,6,6-tetramethylpiperidine-1-oxyl
Phenothiazine: the following compound

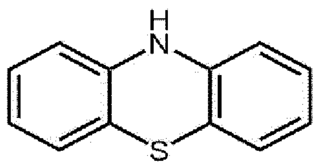

<Color forming substance precursor>

Color forming substance precursor 2: the following Leuco-2

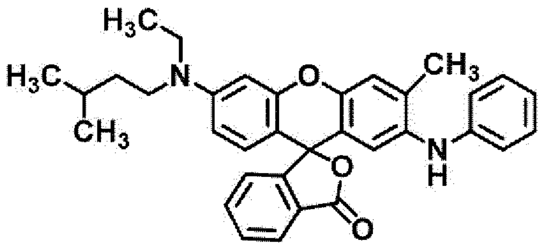

Leuco - 2

Also in the lithographic printing plate precursors of any of the examples, in a case of removing the image-recording layer with MEK, sufficiently washing the support with pure water, and then detecting the absorbate on the surface of the support by element analysis using fluorescent X-rays, it was confirmed that the polymer having an ethylenically unsaturated group and the water-soluble monofunctional monomer were present on the surface of the support on the image-recording layer side.

As is clear from Table 1, the on-press development type lithographic printing plate precursor according to the examples was excellent in printing durability, visibility, and temporal on-press developability as compared with the lithographic printing plate precursor according to the comparative examples.

The disclosure of JP2022-13338 filed on January 31, 2022 is incorporated in the present specification by reference in its entirety.

All documents, patent applications, and technical standards described in the present specification are herein incorporated by reference to the same extent that individual documents, patent applications, and technical standards have been specifically and individually indicated to be incorporated by reference, respectively.

Explanation of References

12a, 12b: aluminum support
18: aluminum plate
20a, 20b: anodic oxide film
22a, 22b: micropore
24: large diameter portion
26: small diameter portion
D: depth of large diameter portion
50: main electrolytic cell
51: alternating current power source
52: radial drum roller
53a, 53b: main pole
54: electrolytic solution supply port
55: electrolytic solution
56: auxiliary anode
57: electrolytic liquid channel
58: auxiliary anode
60: auxiliary anode cell
W: aluminum plate
S: liquid supply direction
Ex: electrolytic solution discharge direction
ta: anodic reaction time
tc: cathodic reaction time
tp: time taken for current to reach peak from 0
Ia: peak current on anodic cycle side
Ic: peak current on cathodic cycle side
AA: current of anodic reaction of aluminum plate
CA: current of cathodic reaction of aluminum plate

## Claims

1. An on-press development type lithographic printing plate precursor comprising:

   a support; and
   an image-recording layer on the support,
   wherein the image-recording layer contains a polymerization initiator, an infrared absorber, a color forming substance precursor, and an auxiliary capable of donating an electron to the infrared absorber, and
   a polymer having an ethylenically unsaturated group and a water-soluble monofunctional monomer are present on a surface of the support on an image-recording layer side, a layer in contact with the support on the image-recording layer side contains the polymer having an ethylenically unsaturated group and the water-soluble monofunctional monomer, or a layer in contact with the support on the image-recording layer side, other than the image-recording layer, contains the polymer having an ethylenically unsaturated group and the image-recording layer contains the water-soluble monofunctional monomer.

2. The on-press development type lithographic printing plate precursor according to claim 1, wherein the polymer having an ethylenically unsaturated group has a polyalkylene oxide chain.

3. The on-press development type lithographic printing plate precursor according to claim 2, wherein the polymer having an ethylenically unsaturated group is a polymer having a constitutional unit having the polyalkylene oxide chain and a constitutional unit having the ethylenically unsaturated group.

4. The on-press development type lithographic printing plate precursor according to any one of claims 1 to 3, wherein a content of the polymer having an ethylenically unsaturated group per unit area of the on-press development type lithographic printing plate precursor is 1 $mg/m^2$ to 30 $mg/m^2$.

5. The on-press development type lithographic printing plate precursor according to any one of claims 1 to 4, wherein a ratio $M^B/M^A$ of a content $M^B$ of the water-soluble monofunctional monomer to a content $M^A$ of the polymer having an ethylenically unsaturated group per unit area of the on-press development type lithographic printing plate precursor is 0.8 to 10.

6. The on-press development type lithographic printing plate precursor according to any one of claims 1 to 5, wherein the water-soluble monofunctional monomer has a support absorptive group.

7. The on-press development type lithographic printing plate precursor according to claim 6, wherein the support absorptive group contained in the water-soluble monofunctional monomer is at least one group selected from the group consisting of a phenolic hydroxy group, a carboxy group, $-PO_3H_2$, $-OPO_3H_2$, $-CONHSO_2-$, $-SO_2NHSO_2-$, and $-COCH_2COCH_3$.

8. The on-press development type lithographic printing plate precursor according to any one of claims 1 to 7, wherein the polymer having an ethylenically unsaturated group and the water-soluble monofunctional monomer are present on the surface of the support on the image-recording layer side.

9. The on-press development type lithographic printing plate precursor according to any one of claims 1 to 8, wherein the polymer having an ethylenically unsaturated group and the water-soluble monofunctional monomer are absorbed on the surface of the support on the image-recording layer side.

10. The on-press development type lithographic printing plate precursor according to any one of claims 1 to 9, further comprising:

    an undercoat layer between the support and the image-recording layer,
    wherein the undercoat layer contains the polymer having an ethylenically unsaturated group and the water-soluble monofunctional monomer.

11. The on-press development type lithographic printing plate precursor according to any one of claims 1 to 10, wherein the polymerization initiator is an onium compound.

12. The on-press development type lithographic printing plate precursor according to any one of claims 1 to 11,

wherein the auxiliary capable of donating an electron to the infrared absorber is a borate compound.

**13.** The on-press development type lithographic printing plate precursor according to any one of claims 1 to 12,

wherein a molar absorption coefficient ε of a color forming substance generated from the color forming substance precursor is 35,000 or more,
a ring-opening ratio of the color forming substance precursor, which is obtained by the following expression, is 40 mol% to 99 mol%, and
a maximum absorption wavelength of the color forming substance generated from the color forming substance precursor, in a wavelength range of 380 nm to 750 nm, is 500 nm to 650 nm,
ring-opening ratio = molar absorption coefficient of the color forming substance obtained in case of adding 1 molar equivalent of acid to the color forming substance precursor/molar absorption coefficient ε of the color forming substance generated from the color forming substance precursor × 100.

**14.** A method of preparing a lithographic printing plate, comprising:

a step of exposing the on-press development type lithographic printing plate precursor according to any one of claims 1 to 13 in a shape of an image; and
a step of supplying at least one selected from the group consisting of a printing ink and dampening water on a printer to remove an image-recording layer in a non-image area.

**15.** A lithographic printing method comprising:

a step of exposing the on-press development type lithographic printing plate precursor according to any one of claims 1 to 13 in a shape of an image;
a step of supplying at least one selected from the group consisting of a printing ink and dampening water on a printer to remove an image-recording layer in a non-image area and to prepare a lithographic printing plate; and
a step of performing printing using the obtained lithographic printing plate.

FIG. 1

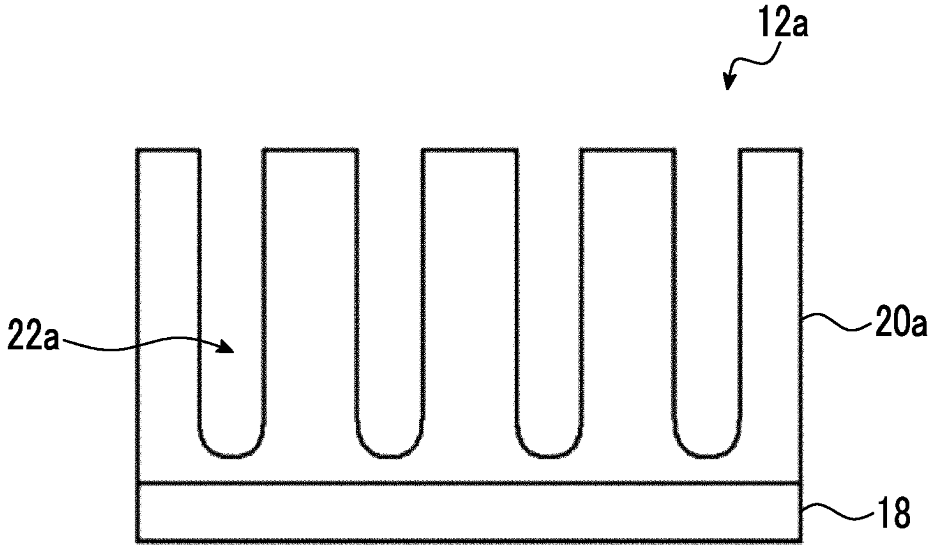


FIG. 2

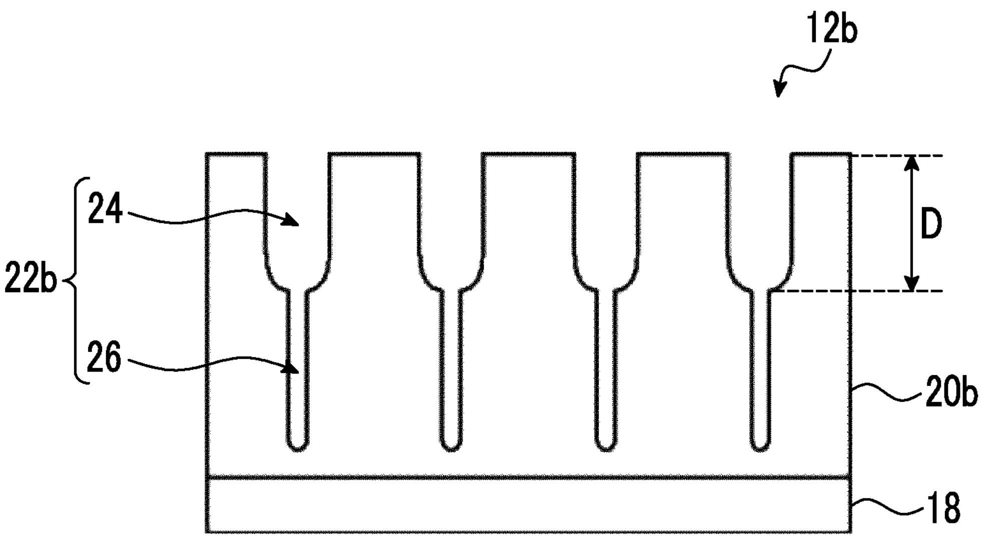

FIG. 3

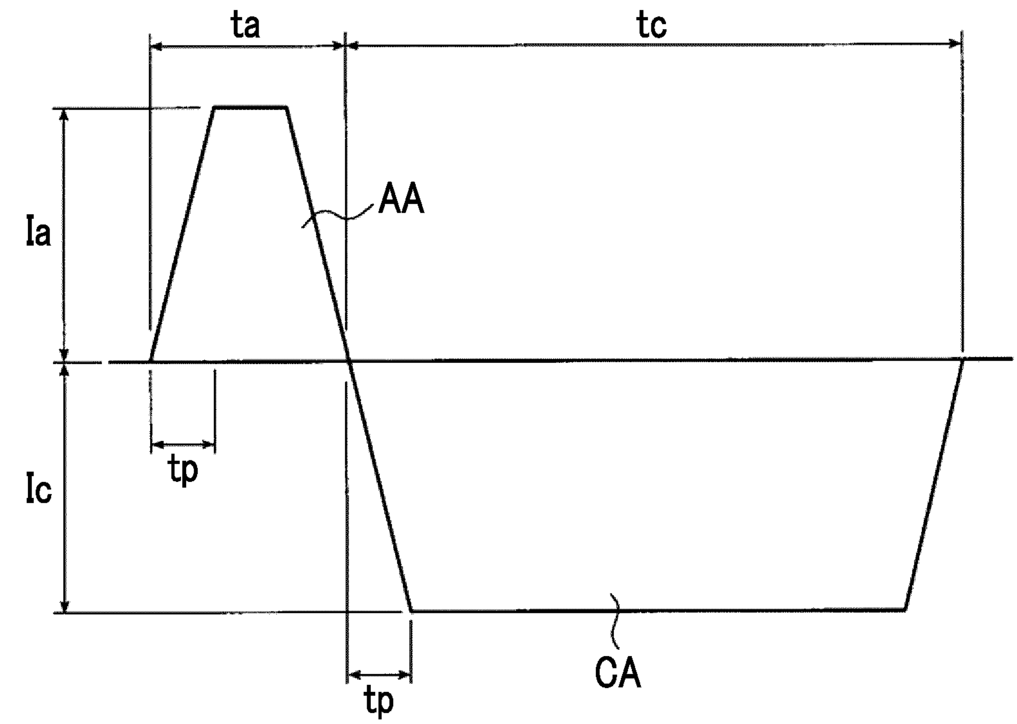


FIG. 4

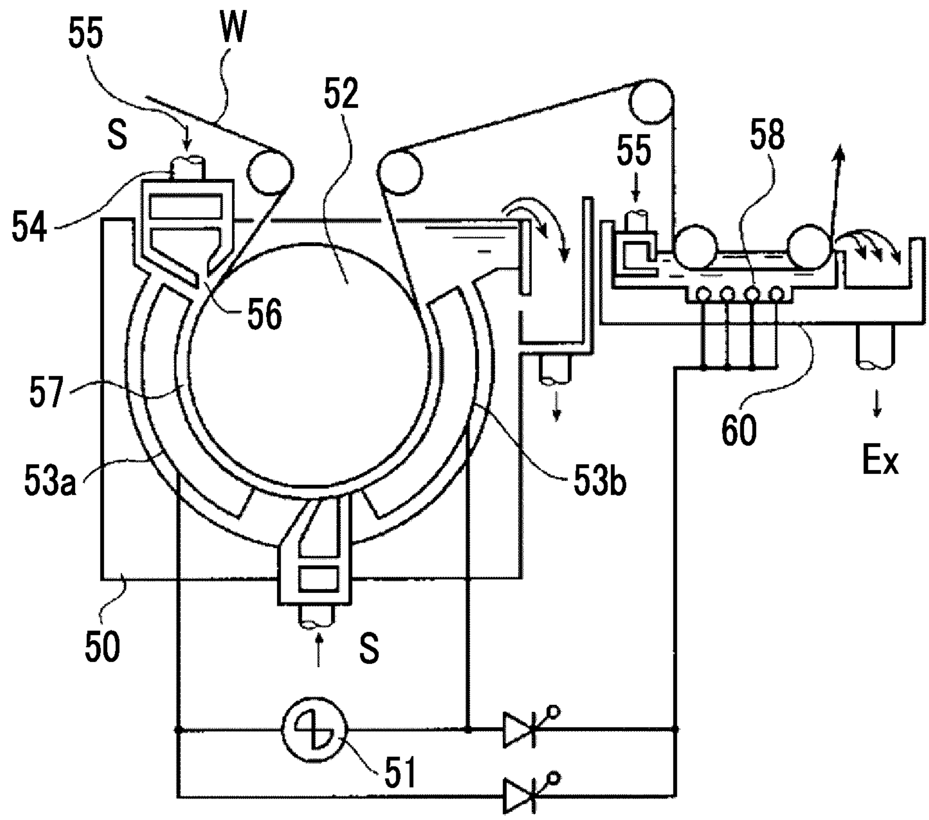

**INTERNATIONAL SEARCH REPORT**

International application No.
**PCT/JP2023/003123**

**A. CLASSIFICATION OF SUBJECT MATTER**

***B41N 1/14***(2006.01)i; ***B41C 1/10***(2006.01)i; ***B41M 1/06***(2006.01)i; ***G03F 7/00***(2006.01)i; ***G03F 7/004***(2006.01)i; ***G03F 7/028***(2006.01)i; ***G03F 7/029***(2006.01)i; ***G03F 7/11***(2006.01)i
FI: B41N1/14; B41C1/10; B41M1/06; G03F7/00 503; G03F7/004 505; G03F7/004 507; G03F7/11 503; G03F7/029; G03F7/028

According to International Patent Classification (IPC) or to both national classification and IPC

**B. FIELDS SEARCHED**

Minimum documentation searched (classification system followed by classification symbols)

B41N1/14; B41C1/10; B41M1/06; G03F7/00; G03F7/004; G03F7/028; G03F7/029; G03F7/11

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br><br>Y | JP 2020-93518 A (FUJIFILM CORPORATION) 18 June 2020 (2020-06-18)<br>claims 1-25, paragraphs [0383]-[0389], [0397]-[0455] | 1, 4-5, 11-12, 14-15<br><br>1-15 |
| Y | JP 2013-57747 A (FUJIFILM CORPORATION) 28 March 2013 (2013-03-28)<br>claims 1-18, paragraphs [0027]-[0110], [0237]-[0316] | 1-15 |
| Y | WO 2020/262692 A1 (FUJIFILM CORPORATION) 30 December 2020 (2020-12-30)<br>claims 1-39, paragraphs [0553]-[0706] | 13 |
| A | JP 2005-41206 A (FUJI PHOTO FILM COMPANY, LIMITED) 17 February 2005 (2005-02-17)<br>entire text | 1-15 |
| A | WO 2016/136654 A1 (FUJIFILM CORPORATION) 01 September 2016 (2016-09-01)<br>entire text | 1-15 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **29 March 2023** | **11 April 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

INTERNATIONAL SEARCH REPORT

International application No. PCT/JP2023/003123

C. DOCUMENTS CONSIDERED TO BE RELEVANT

| Category* | Citation of document, with indication, where appropriate, of the relevant passages | Relevant to claim No. |
|---|---|---|
| A | WO 2012/054237 A1 (EASTMAN KODAK COMPANY) 26 April 2012 (2012-04-26) whole document | 1-15 |

Form PCT/ISA/210 (second sheet) (January 2015)

**INTERNATIONAL SEARCH REPORT**
**Information on patent family members**

International application No.
**PCT/JP2023/003123**

| Patent document cited in search report | Publication date (day/month/year) | Patent family member(s) | Publication date (day/month/year) |
|---|---|---|---|
| JP 2020-93518 A | 18 June 2020 | WO 2020/111259 A1 | |
| JP 2013-57747 A | 28 March 2013 | (Family: none) | |
| WO 2020/262692 A1 | 30 December 2020 | US 2022/0111629 A1<br>claims 1-24, paragraphs [1183]-[1549]<br>EP 3991986 A1<br>CN 114051598 A | |
| JP 2005-41206 A | 17 February 2005 | US 2005/0008971 A1<br>whole document<br>EP 1495866 A2<br>CN 1577087 A | |
| WO 2016/136654 A1 | 01 September 2016 | (Family: none) | |
| WO 2012/054237 A1 | 26 April 2012 | US 2012/0090486 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002287334 A
- JP 10282679 A
- JP H10282679 A
- JP 2304441 A
- JP H2304441 A
- JP 2008195018 A
- JP 8108621 A
- JP H8108621 A
- JP 61166544 A
- JP S61166544 A
- JP 2002328465 A
- WO 2020262692 A
- JP 2001133969 A
- JP 2002023360 A
- JP 2002040638 A
- JP 2002278057 A
- JP 2007090850 A
- JP 2012206495 A
- JP 5005005 A
- JP H055005 A
- JP 2001222101 A
- JP 2008544322 A
- WO 2016027886 A
- WO 2019219560 A
- WO 2019013268 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- JP 2008503365 A
- JP 2012148555 A
- JP 2008284817 A
- JP 2019162855 A
- JP 5045885 A
- JP H545885 A
- JP 6035174 A
- JP H635174 A
- US 3458311 A
- JP 55049729 B
- JP S5549729 B
- JP 2005250216 A
- JP 2006259137 A
- JP 2022013338 A


### Non-patent literature cited in the description


- Society of Synthetic Organic Chemistry. 1970